# EUROPEAN PATENT APPLICATION

(11) **EP 2 978 037 A1**
(43) Date of publication of application: **27.01.2016**
(21) Application number: 14425100.6
(22) Date of filing: 24.07.2014
(51) Int. Cl.: H01L 51/52, H01L 51/54

(54) **Organic electroluminescent transistor**

(71) Applicant: E.T.C. S.r.l., 40129 Bologna BO (IT); Polyera Corporation, Skokie, IL 60077 (US)
(72) Inventor: Biondo, Viviana, 33028 Illegio Tolmezzo UD (IT); Generali, Gianluca, 40127 Bologna BO (IT); Stefani, Andrea, 38121 Trento TN (IT); Muccini, Michele, 40121 Bologna BO (IT); Denti, Mitchell, Chicago, IL 60626 (US); Usta, Hakan, 38010 Kayseri (TR); Facchetti, Antonio, Chicago, IL 60640 (US)
(74) Representative: Barbaro, Gaetano

(57) **Abstract**

This disclosure relates to an organic electroluminescent transistor with improved light emission characteristics. More specifically, the present organic electroluminescent transistor has an emissive ambipolar channel that includes at least one layer of an n-type semiconductor material, at least one layer of a p-type semiconductor material and at least one layer of an emissive material arranged between the layers of p-type and n-type semiconductor materials; the p-type semiconductor layer is suitable to transport holes across the ambipolar channel of the transistor and the p-type semiconductor material comprises a condensed polycyclic aromatic compound having general formula (P-I) 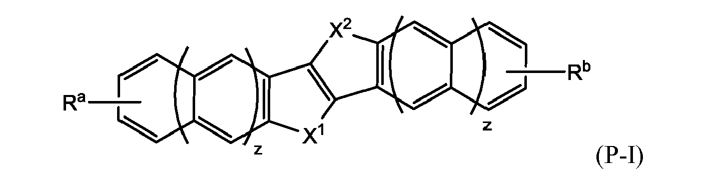 wherein
X¹ and X² are selected from the group consisting of S, O and Se;
R^{a} and R^{b} are independently selected from the group consisting of H, a C₁₋₁₈ alkyl group, and a C₆₋₁₄ aryl group, wherein each C₁₋₁₈ alkyl group and each C₆₋₁₄ aryl group optionally can be substituted with a phosphonate group; and z is 0 or 1.

## Description

### BACKGROUND

This invention relates to an organic electroluminescent transistor with improved light emission characteristics.

The present description and the enclosed claims refer to the light emission characteristics, and in particular to the simultaneous achievement of maximum brightness and efficiency, of an electroluminescent transistor based on a multilayer structure.

Organic electroluminescent field effect transistors, also known as OLETs (Organic Light Emitting Transistors) are a relatively recent type of devices, that have characteristics and potentialities that make them particularly interesting. In particular, compared with OLEDs (Organic Light Emitting Diodes), ambipolar OLETs have enhanced efficiency and luminosity, and also the possibility of using low-cost production processes, once they have been optimized.

Further details about the structure of an ambipolar OLET device may be found in European Patent No. EP 1609195. More specifically, EP 1609195 upon the teaching of which the preamble of the enclosed claim 1 is drafted, discloses a three-layer organic light emitting transistor having an emissive ambipolar channel comprising at least one layer of an n-type semiconductor material, at least one layer of a p-type semiconductor material and at least one layer of an emissive material arranged between said layers of p-type and n-type semiconductor materials. Further details about the potentialities and the functional characteristics of these devices may be found in the article "Organic light-emitting transistors with an efficiency that outperforms the equivalent light-emitting diodes" published in 2010 by Nature Materials, Volume 9, pages 496-503. The three-layer organic light emitting transistor disclosed in the article has a layer of an n-type semiconductor material composed of 5,5'-bis((5-perfluorohexyl)thiophen-2-yl)-2,2'-bithiophene (DFH4T), a layer of a p-type semiconductor material composed of 5,5'-bis(3-hexyl-2-thienyl)-2,2'-bithiophene (DH4T), and a layer of an emissive material composed of tris(8-hydroxyquinolinato)aluminium:4-(dicyanomethylene)-2-methyl-6-(p-dimethylaminostyryl)-4H-pyran (Alq₃:DCM).

So far, all studies and characterizations have shown that ambipolar OLET devices have an enhanced luminosity, though obtained at bias conditions where the efficiency of charge current conversion into light emission is very low (in the order of 1 x 10⁻¹ %). Conversely, the device efficiency can be usually maximized by modifying its bias conditions but with detrimental effects on the luminosity. These emission characteristics limit the possible application fields when high brightness and high efficiency are simultaneously needed, such as for example in the field of the technology of light emitting displays, of the so-called biomedical applications Point of Care, of sources at high integrated luminosity on photonic chips. Further improvement in electroluminescence intensity (from the order of nanoWatt (nW) to microWatt (µW) with constant device geometry) also is desirable.

### SUMMARY

An objective of this disclosure is to provide an organic electroluminescent transistor for overcoming the above mentioned drawbacks of prior art, with particular reference to maximize simultaneously the light emission efficiency and brightness of the OLET and of the device containing it.

Generally, an organic electroluminescent transistor according to this disclosure comprises at least one dielectric layer, at least one control electrode, an assembly comprising an emissive ambipolar channel, at least one source electrode and at least one drain electrode, wherein:
the dielectric layer is arranged between the control electrode and the assembly;
the ambipolar channel comprises at least one layer of an n-type semiconductor material, at least one layer of a p-type semiconductor material and at least one layer of an emissive material arranged between the layers of p-type and n-type semiconductor materials; and
the p-type semiconductor material is suitable to transport holes across the ambipolar channel of the transistor and comprises a condensed polycyclic aromatic compound having general formula (P-I) 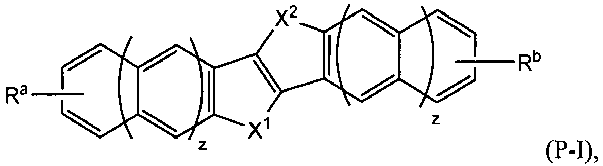 wherein
   X¹ and X² are selected from the group consisting of S, O and Se;
   R^{a} and R^{b} are independently selected from the group consisting of H, a C₁₋₁₈ alkyl group, and a C₆₋₁₄ aryl group, wherein each C₁₋₁₈ alkyl group and each C₆₋₁₄ aryl group optionally can be substituted with a phosphonate group; and
   z is 0 or 1.

In one embodiment, the n-type semiconductor material is a bis(p-fluoroalkyl)phenyl-substituted thieno[3,2-b]thiophene, non-limiting examples of which include 2,5-bis(4-(perfluorooctyl)phenyl)thieno[3,2-b]thiophene (NF2-6) and 2,5-bis(4-(trifluoromethyl)phenyl)thieno[3,2-b]thiophene (NF2-6-CF3).

In one embodiment, the emissive layer is selected among 4,4',4"-tris(carbazole-9-yl)triphenylamine:tris(1-phenylisoquinoline)iridium(III) (TCTA:Ir(piq)₃), 4,4'-bis(3,6-dineopentyl-9H-carbazole-9-yl)-1,'-biphenyl:aris(1-phenylisoquinoline)iridium(III) (NP4-CBP:Ir(piq)₃), 4,4'-bis(3,6-dineopentyl-9H-carbazole-9-yl)-1,'-biphenyl:tris(2-phenylpyridine)iridium(III) (NP4-CBP:Ir(ppy)), 4,4'-bis(3,6-dineopentyl-9H-carbazole-9-yl)-1,'-biphenyl:bis(4,6-difluorophenyl-pyridine)(picolinate)iridium(III) (NP4-CBP:FIrpic).

In various embodiments, the organic electroluminescent transistor can include one or more additional layers selected from the group consisting of a hole-injection sublayer, an electron-injection sublayer, and a passivation layer. In one embodiment, as example, the source electrode is in contact with the layer of p-type semiconductor material and the drain electrode is in contact with the layer of n-type semiconductor material. In another embodiment, an injection sublayer can be interposed between the source electrode and the layer of p-type or n-type semiconductor material and/or an injection sublayer is interposed between the drain electrode and the layer of p-type or n-type semiconductor material.

The foregoing as well as other features and advantages of the present teachings will be more clearly understood from the following figures, description, examples, and claims. The claims as filed are an integral part of this specification and are herein incorporated by reference.

### BRIEF DESCRIPTION OF THE DRAWINGS

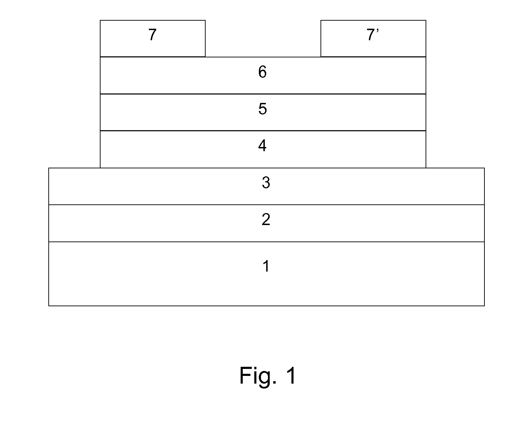

Figure 1 is a cross-sectional view of an organic light emitting transistor (OLET) according to this disclosure, which includes a substrate (1), a control electrode (2), a dielectric layer (3), an assembly comprising an emissive ambipolar channel that includes a layer of a first-type of semiconductor material (4), a layer of an emissive material (5), and a layer of a second-type of semiconductor material (6), and a electron electrode and a hole electrode (7 and 7').

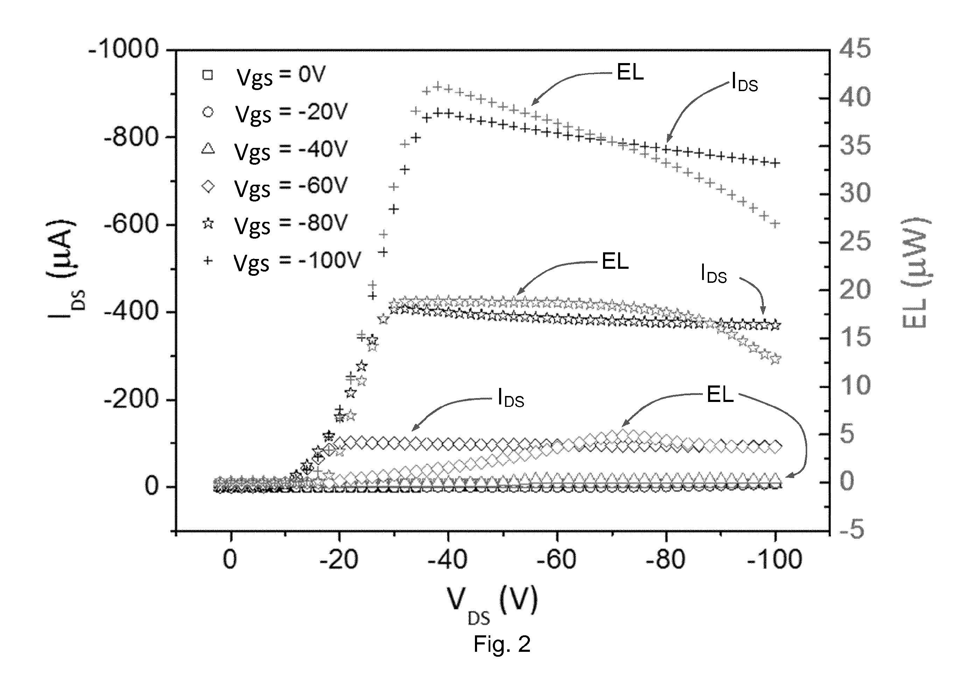

Figure 2 depicts graphs of the drain-source current I_{DS} (left scale - black curves) and of the electro-luminescence optical output power EL (right scale - gray curves) as a function of the drain-source voltage V_{DS} at different values of the gate-source voltage V_{GS}, for an electroluminescent transistor according to a first exemplary embodiment.

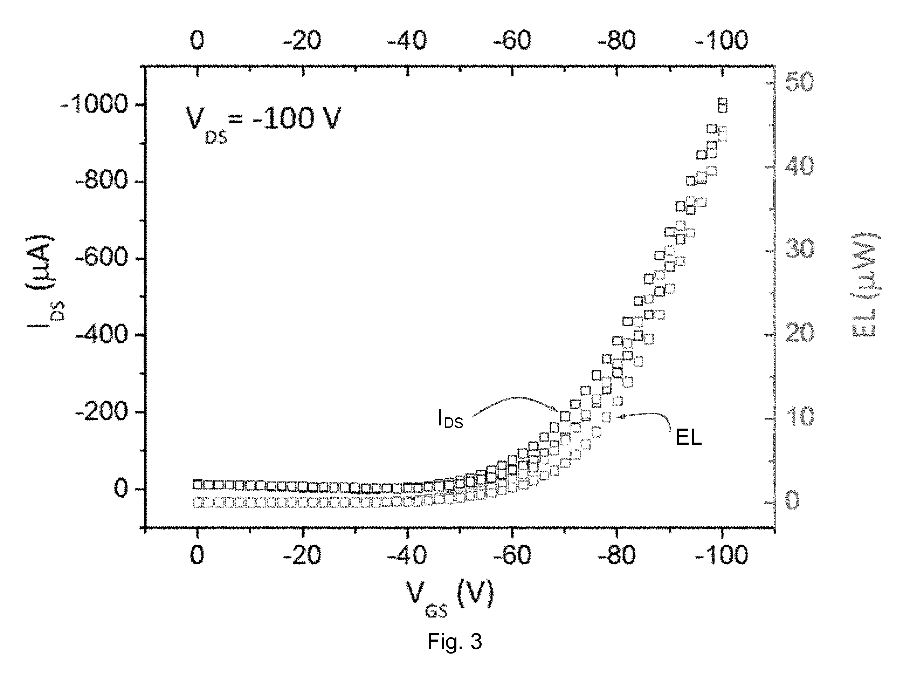

Figure 3 depicts graphs of the drain-source current I_{DS} (left scale - black curve) and of the electro-luminescence optical output power EL (right scale - gray curves) as a function of the gate-source voltage V_{GS} whilst the drain contact was maintained at a constant bias voltage of -100V and the source contact was grounded (V_{DS} = -100V), for the electroluminescent transistor according to the first exemplary embodiment.

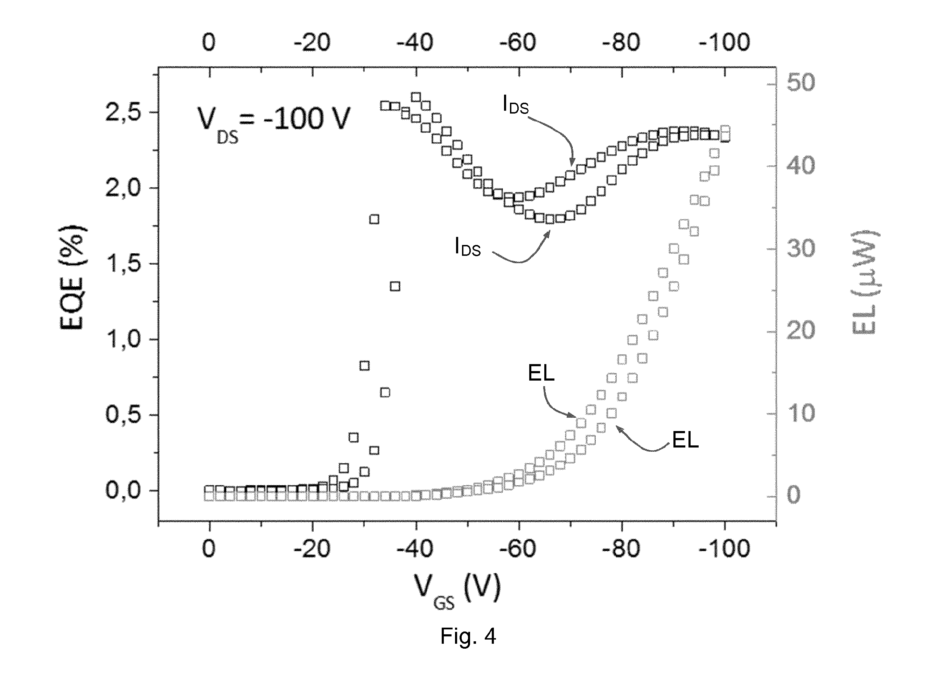

Figure 4 depicts graphs of the external quantum efficiency (left scale - black curve) and of the electro-luminescence optical output power EL (right scale - gray curves) as a function of the gate-source voltage V_{GS} whilst the drain contact was maintained at a constant bias voltage of -100V and the source contact was grounded (V_{DS} = -100V), for the electroluminescent transistor according to the first exemplary embodiment.

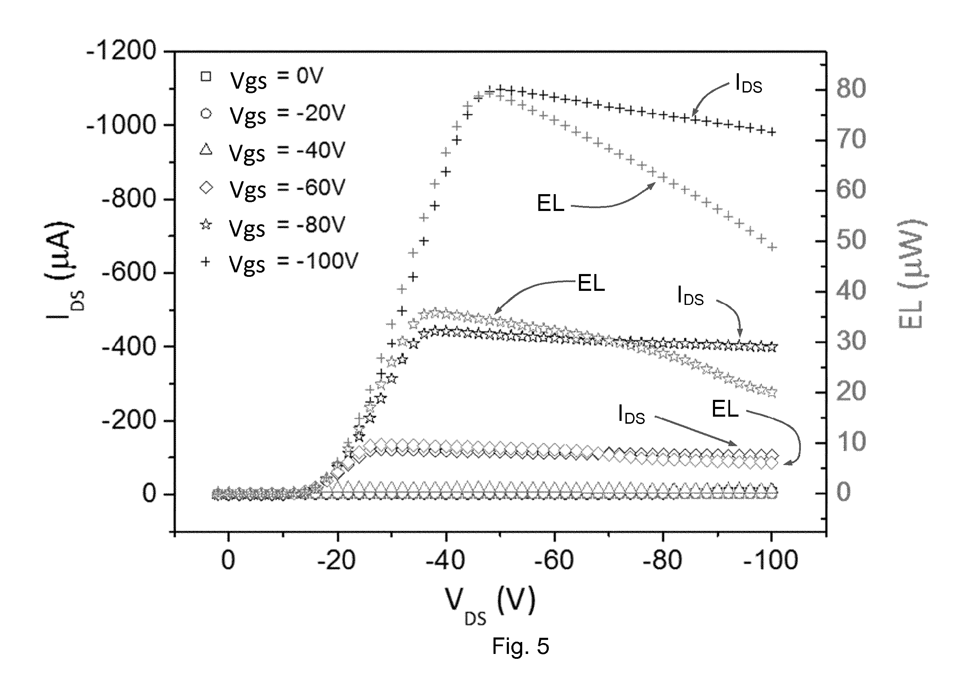

Figure 5 depicts graphs of the drain-source current I_{DS} (left scale - black curves) and of the electro-luminescence optical output power EL (right scale - gray curves) as a function of the drain-source voltage V_{DS} at different values of the gate-source voltage V_{GS}, for an electroluminescent transistor according to a second exemplary embodiment.

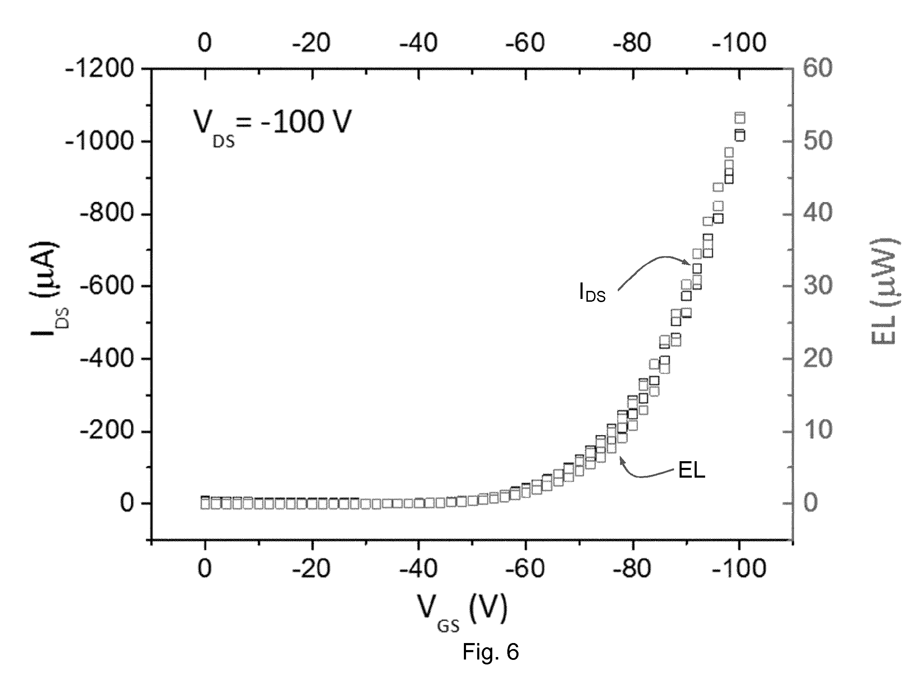

Figure 6 depicts graphs of the drain-source current I_{DS} (left scale - black curve) and of the electro-luminescence optical output power EL (right scale - gray curves) in function of the gate-source voltage V_{GS} whilst the drain contact was maintained at a constant bias voltage of -100V and the source contact was grounded (V_{DS} = -100V), for the electroluminescent transistor according to the second exemplary embodiment.

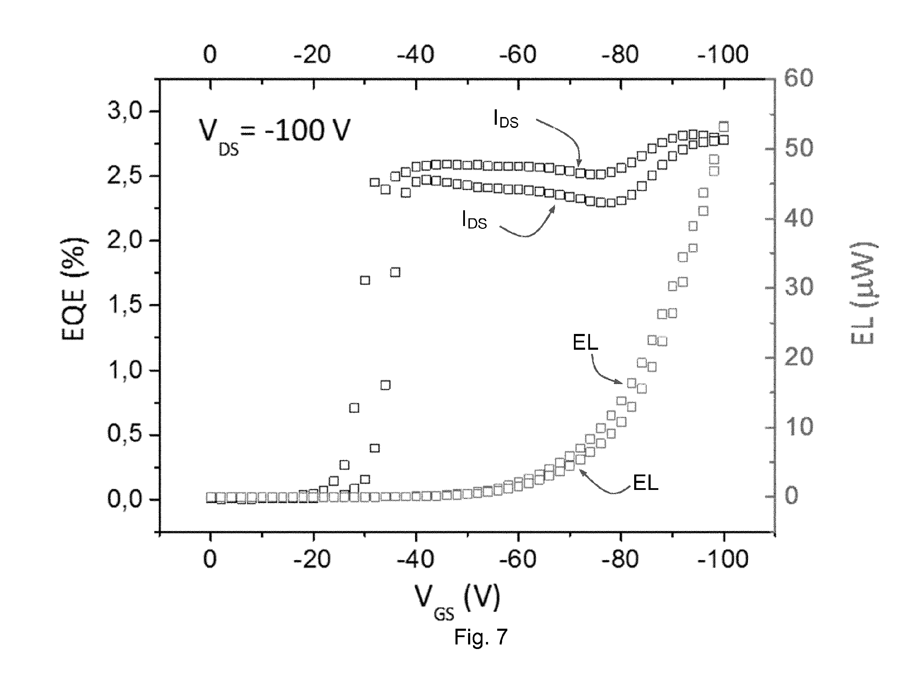

Figure 7 depicts graphs of the external quantum efficiency (left scale - black curve) and of the electro-luminescence optical output power EL (right scale - gray curves) as a function of the gate-source voltage V_{GS} whilst the drain contact was maintained at a constant bias voltage of -100V and the source contact was grounded (V_{DS} = -100V), for the electroluminescent transistor according to the second exemplary embodiment.

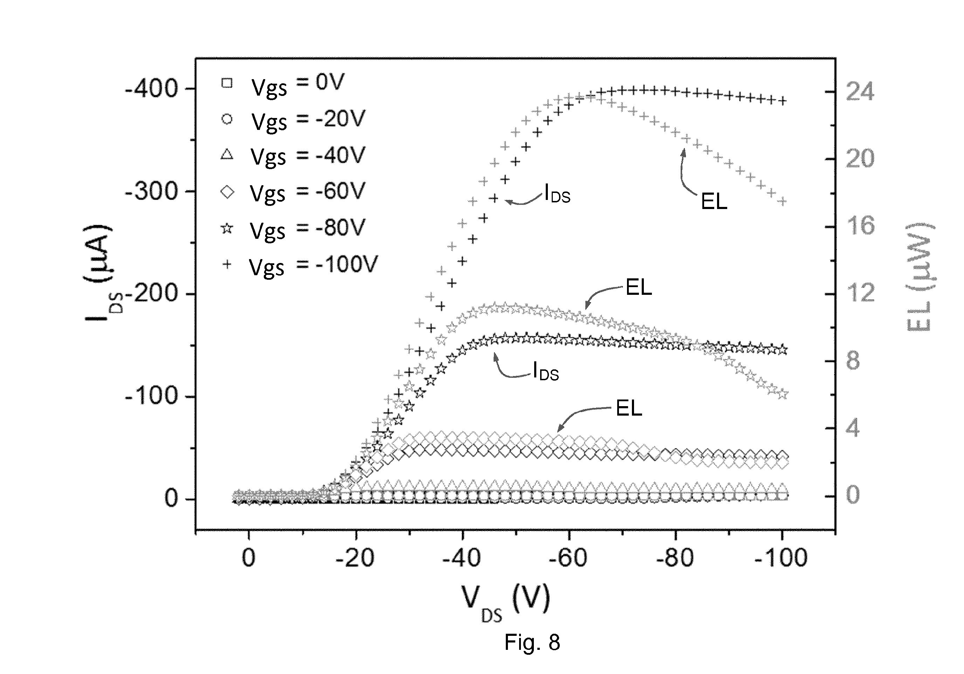

Figure 8 depicts graphs of the drain-source current I_{DS} (left scale - black curves) and of the electro-luminescence optical output power EL (right scale - gray curves) as a function of the drain-source voltage V_{DS} at different values of the gate-source voltage V_{GS}, for an electroluminescent transistor according to a third exemplary embodiment.

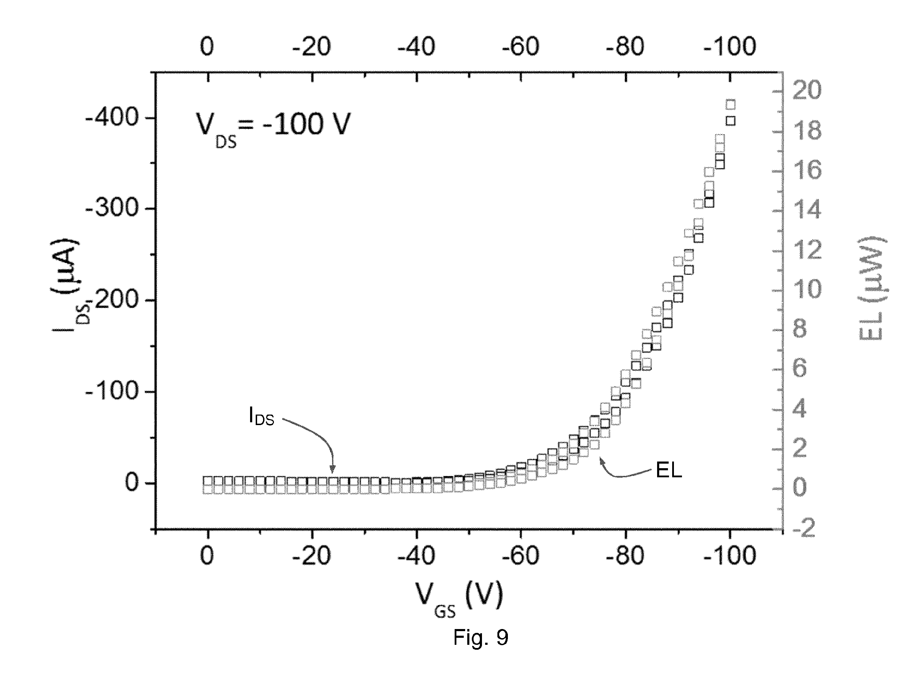

Figure 9 depicts graphs of the drain-source current I_{DS} (left scale - black curve) and of the electro-luminescence optical output power EL (right scale - gray curves) in function of the gate-source voltage V_{GS} whilst the drain contact was maintained at a constant bias voltage of -100V and the source contact was grounded (V_{DS} = -100V), for the electroluminescent transistor according to the third exemplary embodiment.

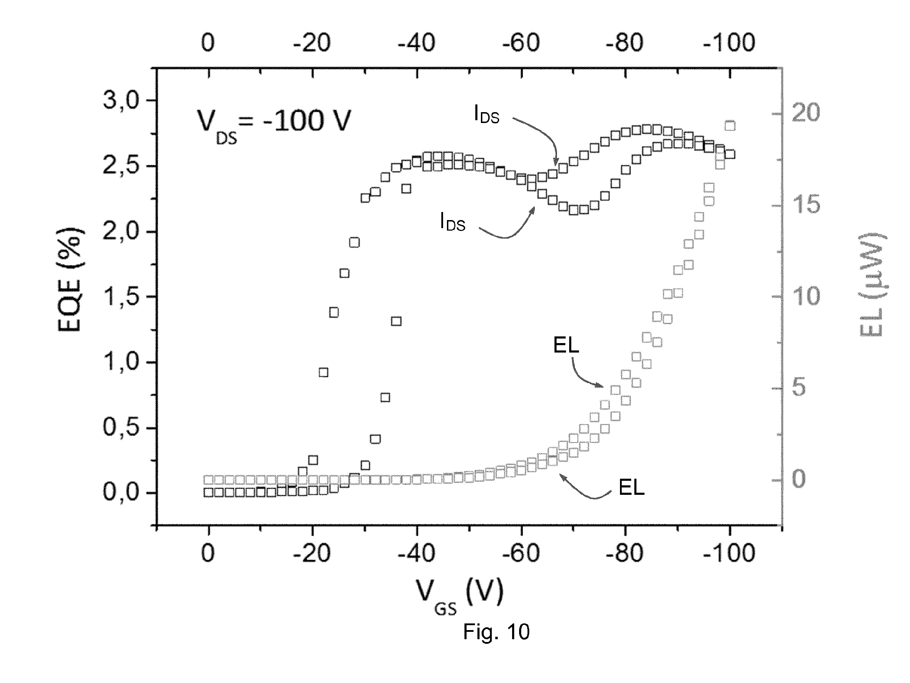

Figure 10 depicts graphs of the external quantum efficiency (left scale - black curve) and of the electro-luminescence optical output power EL (right scale - gray curves) as a function of the gate-source voltage V_{GS} whilst the drain contact was maintained at a constant bias voltage of -100V and the source contact was grounded (V_{DS} = -100V), for the electroluminescent transistor according to the third exemplary embodiment.

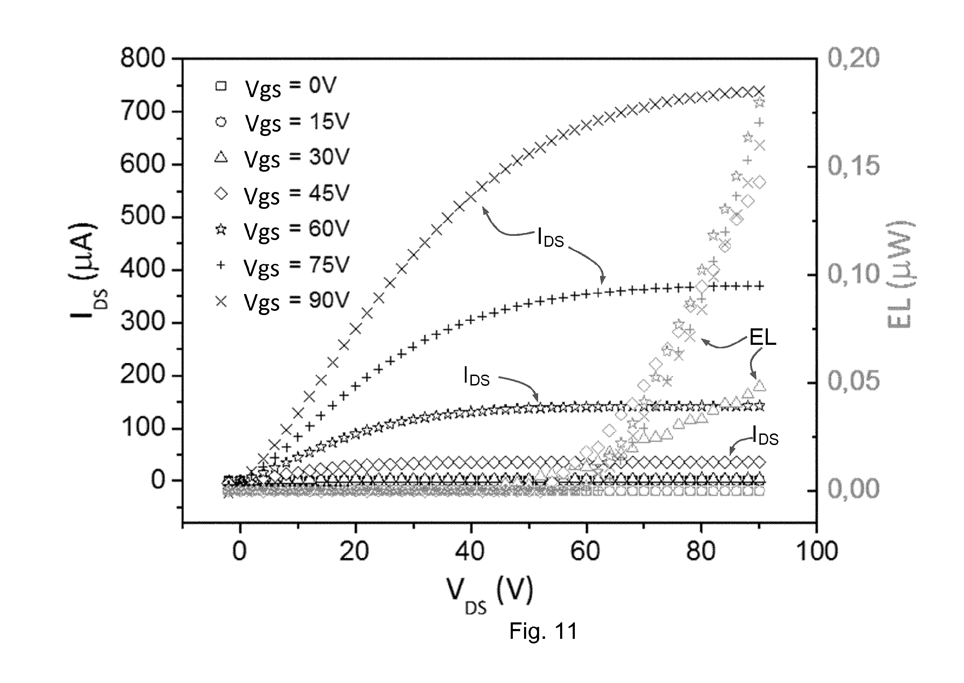

Figure 11 depicts graphs of the drain-source current (I_{DS}) (left scale - black curves) and the electro-luminescence optical output power (EL) (right scale - gray curves) as a function of the drain-source voltage (V_{DS}) at different values of the gate-source voltage (V_{GS}), for a first comparative electroluminescent transistor not according to the present invention.

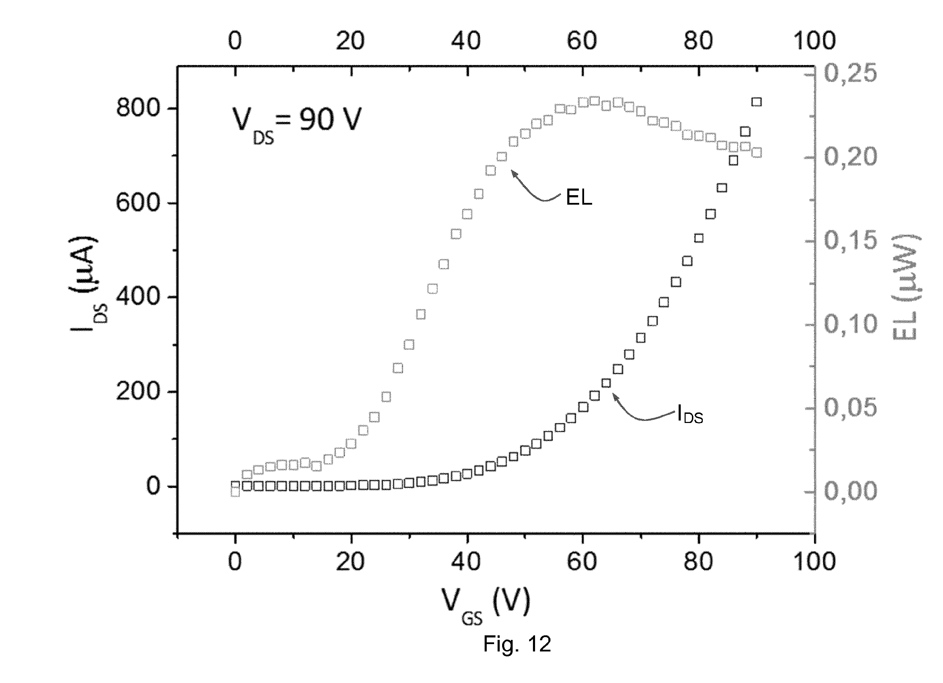

Figure 12 depicts graphs of the drain-source current I_{DS} (left scale - black curve) and of the electro-luminescence optical output power EL (right scale - gray curves) in function of the gate-source voltage V_{GS} whilst the drain contact was maintained at a constant bias voltage of 90V and the source contact was grounded (V_{DS} = 90V), for the first comparative electroluminescent transistor.

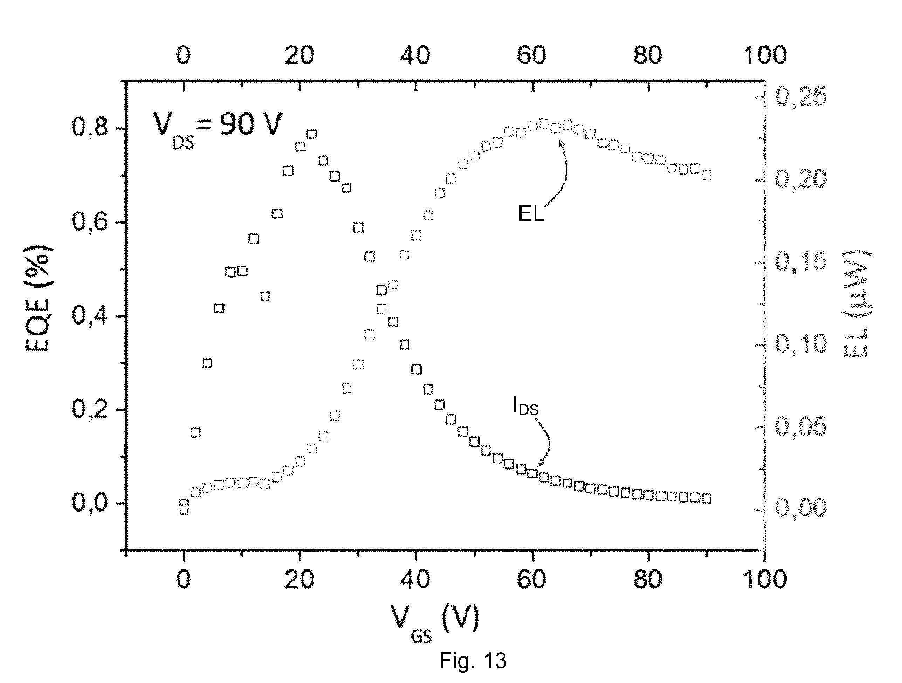

Figure 13 depicts graphs of the external quantum efficiency (left scale - black curve) and of the electro-luminescence optical output power EL (right scale - gray curves) as a function of the gate-source voltage V_{GS} whilst the drain contact was maintained at a constant bias voltage of 90V and the source contact was grounded (V_{DS} = 90V), for the first comparative electroluminescent transistor.

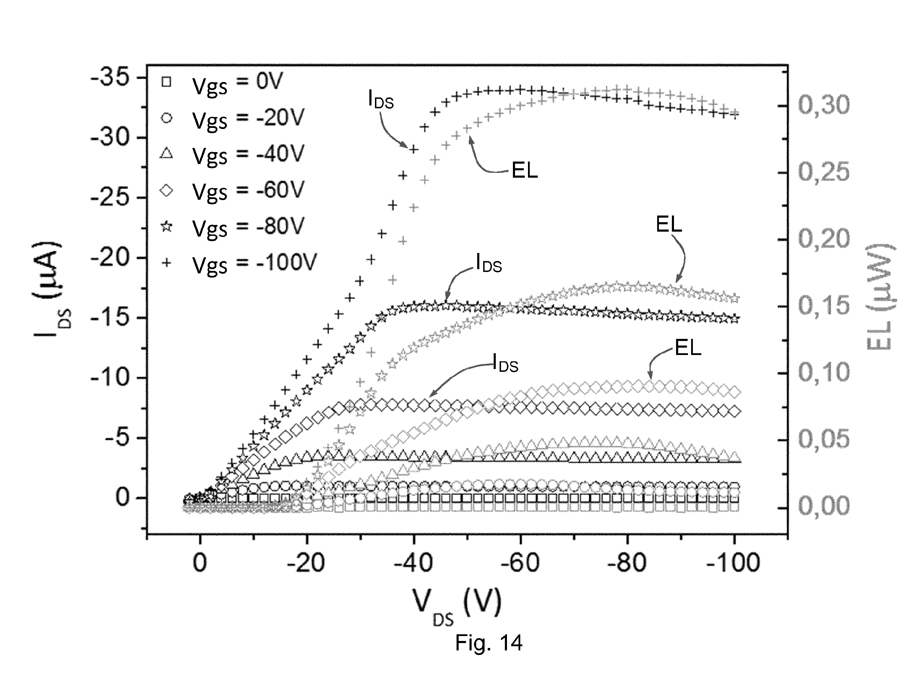

Figure 14 depicts graphs of the drain-source current I_{DS} (left scale - black curves) and of the electro-luminescence optical output power EL (right scale - gray curves) as a function of the drain-source voltage V_{DS} at different values of the gate-source voltage V_{GS}, for a second comparative electroluminescent transistor not according to the present invention.

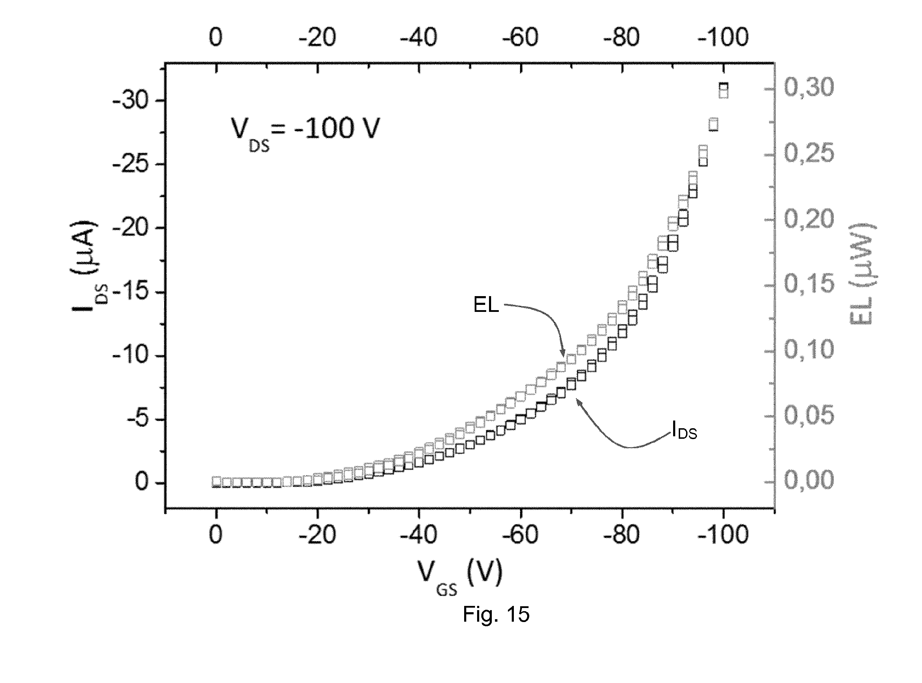

Figure 15 depicts graphs of the drain-source current I_{DS} (left scale - black curve) and of the electro-luminescence optical output power EL (right scale - gray curves) in function of the gate-source voltage V_{GS} whilst the drain contact was maintained at a constant bias voltage of -100V and the source contact was grounded (V_{DS} = -100V), for the second comparative electroluminescent transistor.

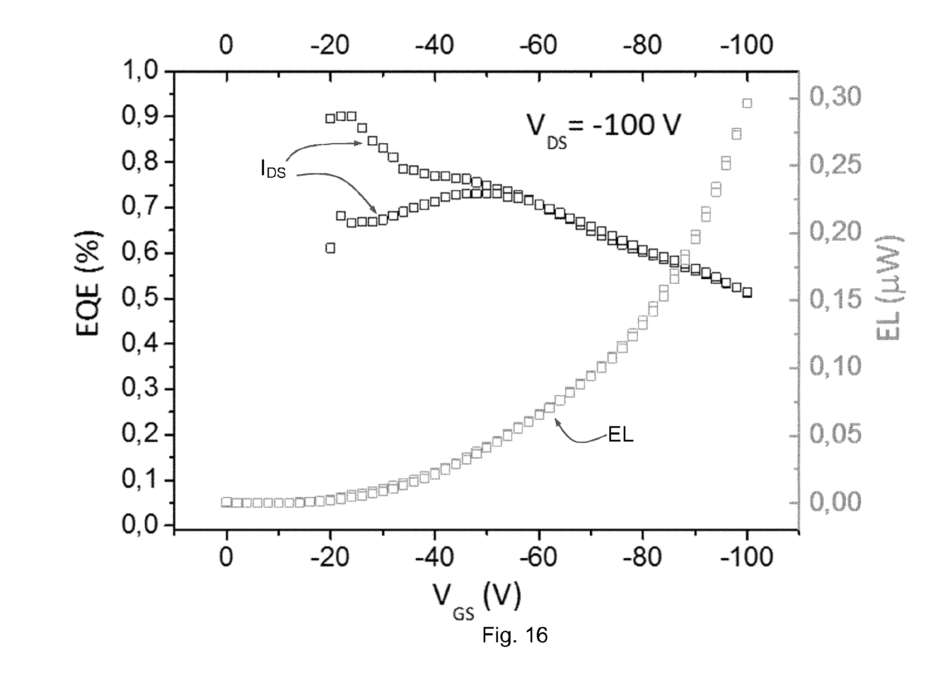

Figure 16 depicts graphs of the external quantum efficiency (left scale - black curve) and of the electro-luminescence optical output power EL (right scale - gray curves) as a function of the gate-source voltage V_{GS} whilst the drain contact was maintained at a constant bias voltage of -100V and the source contact was grounded (V_{DS} = -100V), for the second comparative electroluminescent transistor.

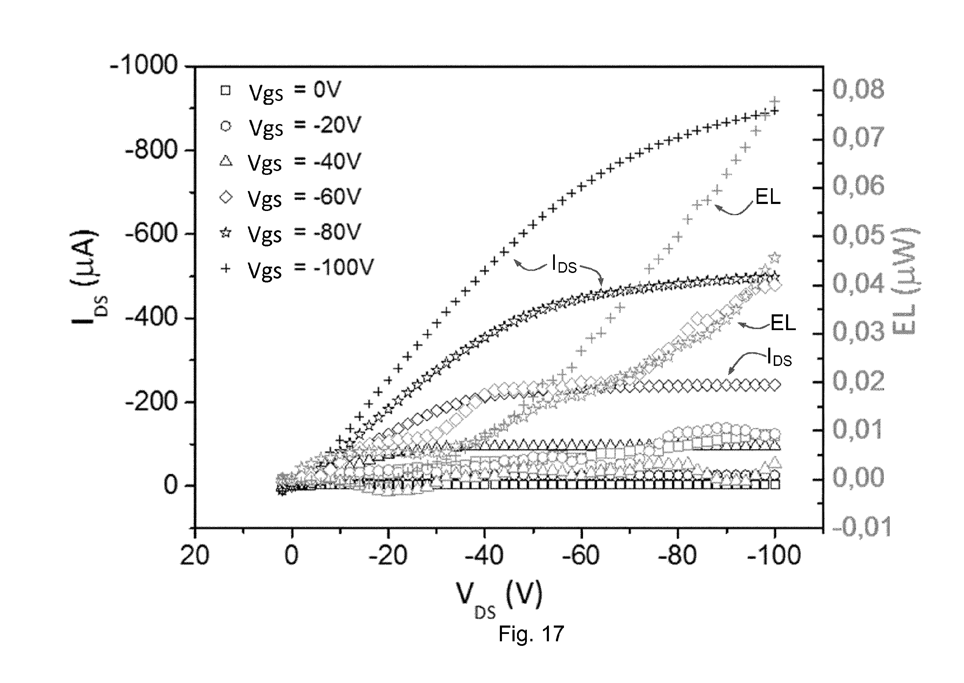

Figure 17 depicts graphs of the drain-source current I_{DS} (left scale - black curves) and of the electro-luminescence optical output power EL (right scale - gray curves) as a function of the drain-source voltage V_{DS} at different values of the gate-source voltage V_{GS}, for a third comparative electroluminescent transistor not according to the present invention.

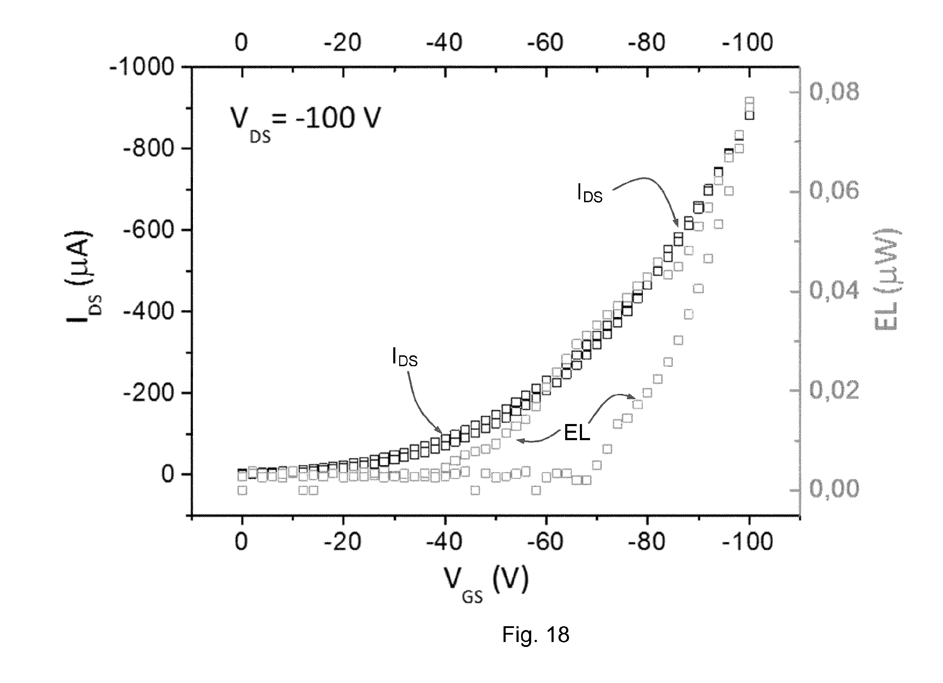

Figure 18 depicts graphs of the drain-source current I_{DS} (left scale - black curve) and of the electro-luminescence optical output power EL (right scale - gray curves) in function of the gate-source voltage V_{GS} whilst the drain contact was maintained at a constant bias voltage of -100V and the source contact was grounded (V_{DS} = -100V), for the third comparative electroluminescent transistor.

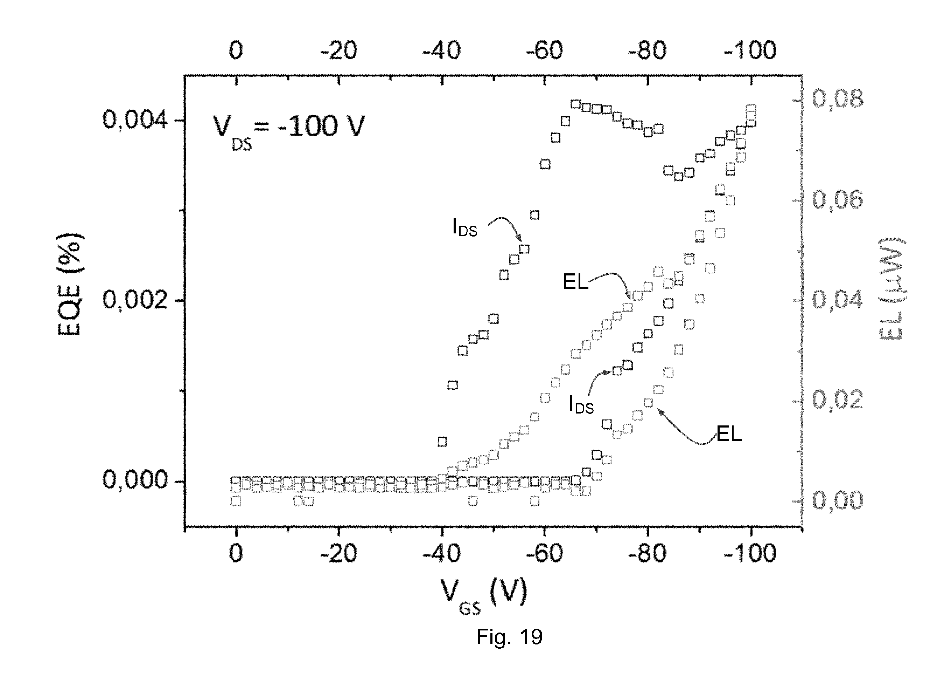

Figure 19 depicts graphs of the external quantum efficiency (left scale - black curve) and of the electro-luminescence optical output power EL (right scale - gray curves) as a function of the gate-source voltage V_{GS} whilst the drain contact was maintained at a constant bias voltage of -100V and the source contact was grounded (V_{DS} = -100V), for the third comparative electroluminescent transistor.

### DETAILED DESCRIPTION

An embodiment of an electroluminescent transistor with simultaneous maximum brightness and efficiency according to this disclosure is shown in figure 1.

In this particular embodiment, the electroluminescent transistor comprises a substrate 1 that acts as a supporting layer, over which there is an electrode 2 that acts as control or gate electrode and that may be a transparent electrode, a layer of dielectric material 3, over which there is a light-emitting assembly. This assembly includes a charge carrier transport layer of a first type 4, a layer 5 of emissive material and a charge carrier transport layer of a second type 6. Source and drain electrodes 7 and 7' are realized so as to inject charge carriers into the light-emitting assembly.

The charge carrier transport layer of the first type 4 for example may be a hole transport layer made of a p-type semiconductor material and the charge carrier transport layer of the second type 6 may be an electron transport layer made of a n-type semiconductor material, though the opposite is possible.

In the shown embodiment, the source and drain electrodes are directly in contact with the charge carrier transport layer of the second type 6. According to an alternative embodiment not shown in the figures, an injection sublayer is interposed between the source electrode and the layer 6 and/or between the drain electrode and the layer 6.

Instead of the bottom-gate architecture depicted in Figure 1, the organic electroluminescent transistor can have a top-gate architecture. Further, the hole and electron electrodes and/or the control electrode can have alternative arrangements as described in International Publication No. WO 2014/035841. Specifically, the hole and electron electrodes can be in contact with different layers of the light-emitting assembly. For example, the hole electrode can be in contact with the layer of p-type semiconductor material, while the electron electrode can be in contact with the layer of n-type semiconductor material. Furthermore, as described in International Publication Nos. WO 2013/018002, WO 2013/017999, WO 2014/035842, and WO 2013/018000, additional control electrode(s) and/or additional layer(s) of dielectric material, emissive material, and/or charge carrier transport materials can be incorporated into the organic electroluminescent transistor. Optionally, a passivation layer can be present covering the top surface of the emissive ambipolar channel.

The inventors have found that organic electroluminescent transistors such as, but not limited to, those configured according to the embodiment shown in Figure 1, can have enhanced light emission if the p-type semiconductor material includes a condensed polycyclic aromatic compound having general formula (P-I) 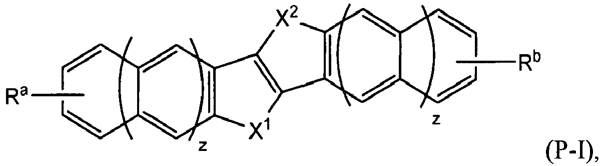 where X¹ and X² are selected from the group consisting of S, O and Se; R^{a} and R^{b} are independently selected from the group consisting of H, a C₁₋₁₈ alkyl group, and a C₆₋₁₄ aryl group, wherein each C₁₋₁₈ alkyl group and each C₆₋₁₄ aryl group optionally can be substituted with a phosphonate group; and z is 0 or 1. In certain embodiments, at least one of R^{a} and R^{b} can be a C₁₋₁₈ alkyl or C₆₋₁₄ aryl group that is optionally substituted with a phosphonate group. For example, at least one of R^{a} and R^{b} can be a C₁₋₁₈ alkyl group optionally substituted with a phosphonate group (e.g., when z is 0).

Yet further enhanced light emission can be obtained if the p-type semiconductor material comprises a benzothieno-benzothiophene compound having general formula (P-II) 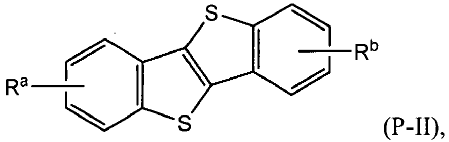 where R^{a} and R^{b} are as defined herein. In a preferred embodiment, the benzothieno-benzothiophene compound can have the formula: 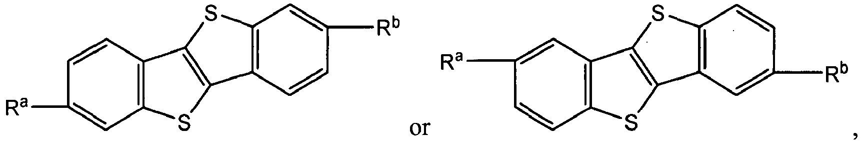 wherein R^{a} and R^{b} are identical C₁₋₁₈ alkyl groups, preferably identical C₃₋₁₂ alkyl groups, and most preferably identical linear C₃₋₁₂ alkyl groups. Specific non-limiting examples include 2,7-dioctyl[1]benzo-thieno[3,2-b][1] benzothiophene (C8-BTBT) and 2,7-dipentyl[1]benzo thieno[3,2-b][1] benzothiophene (C5-BTBT).

In an alternative embodiment, the benzothieno-benzothiophene compound can have the formula: 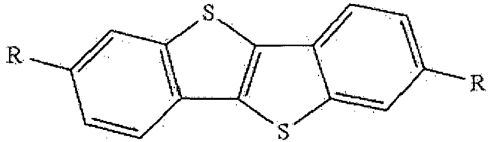 wherein each R can be a phenyl group.

In other embodiments, the p-type semiconductor material can be a dinaphtho-thienothiophene compound having general formula (P-III) 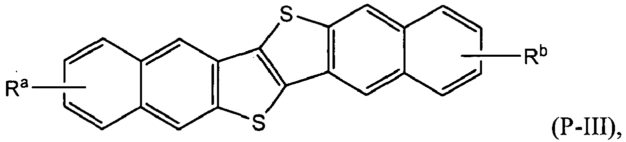 where R^{a} and R^{b} are as defined herein. For example, the dinaphtho-thienothiophene compound can have the formula: 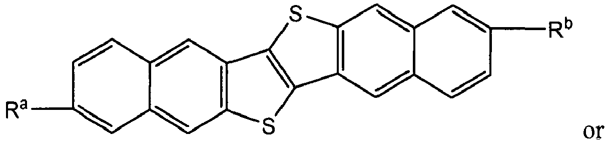 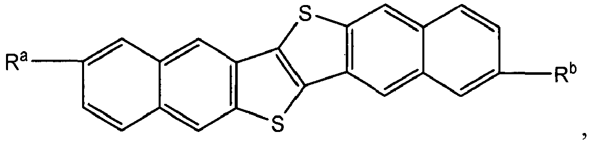 wherein R^{a} and R^{b} are identical C₁₋₁₈ alkyl groups, preferably identical C₃₋₁₂ alkyl groups, and most preferably identical linear C₃₋₁₂ alkyl groups. A specific non-limiting example is dinaphtho[2,3-b:2',3'-f]thieno[3,2-b]thiophene (DNTT).

Further enhanced emissive properties also may be obtained if the emissive material comprises a blend of a host matrix compound represented by either formula (H-1) (TCTA) or formula (H-2) (NP4-CBP) and a guest emitter represented by formula (G-1) (FIrpic), (G-2) (Ir(ppy)), or (G-3) (Ir(piq)₃) as provided below. In various embodiments, the layer of emissive material can include between 10% and 22% of its total weight of the guest emitter.

For example, in embodiments where the emissive material is blue-emitting, the emissive material can include a blend of the arylamine matrix compound of (H-1) and the blue emitter of formula (G-1): 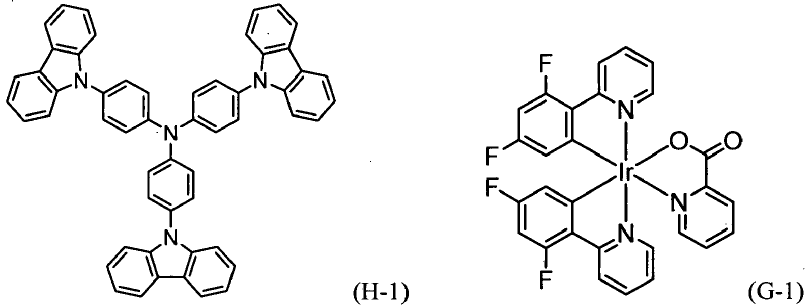 or a blend of the arylamine matrix compound of formula (H-2) and the blue emitter of formula (G-1):

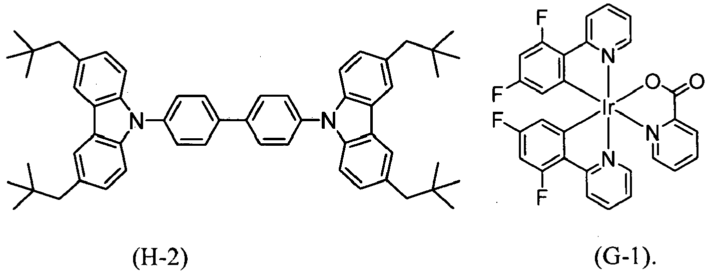

In embodiments where the emissive material is green-emitting, the emissive material can include a blend of the arylamine matrix compound of formula (H-1) and the green emitter of formula (G-2): 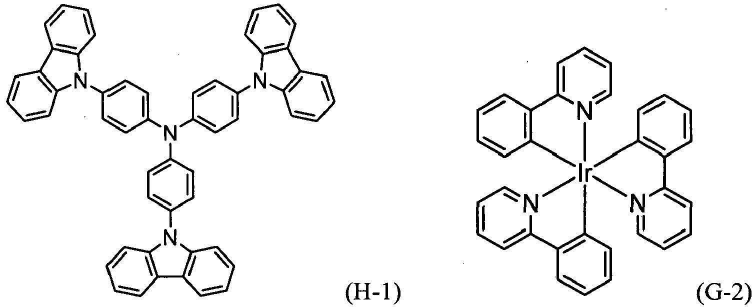 or a blend of the arylamine matrix compound of formula (H-2) and the green emitter of formula (G-2):

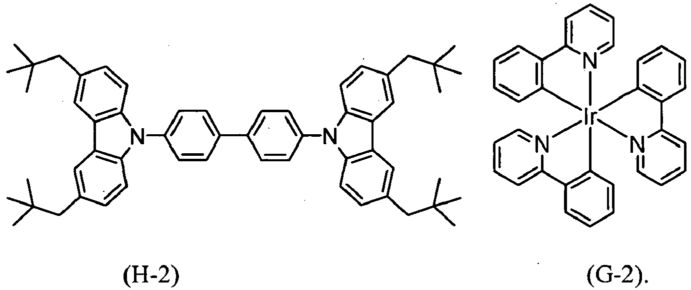

In embodiments where the emissive material is red-emitting, the emissive material can include a blend of the arylamine matrix compound of formula (H-1) and the red emitter of formula (G-3): 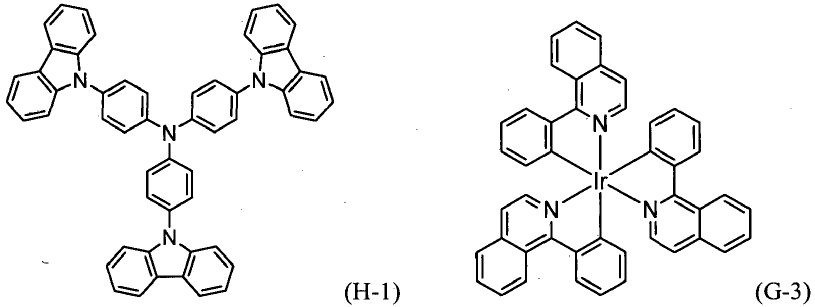 or a blend of the arylamine matrix compound of formula (H-2) and the red emitter of formula (G-3):

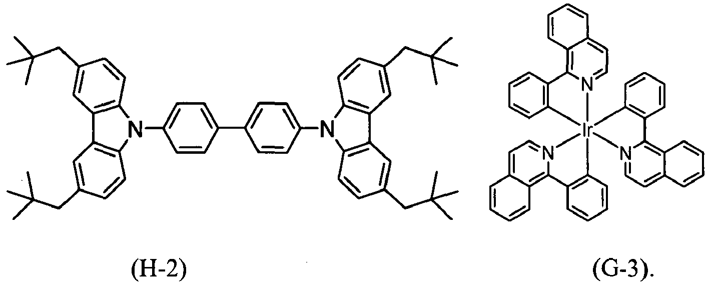

However, the emissive material can be selected from various single-component host-emitting materials and blend materials including a host matrix compound and a guest fluorescent or phosphorescent emitter known in the art. Suitable organic electroluminescent light-emitting materials include those having been used in OLED applications. For example, an alternative emissive material can be a blend of tris(8-hydroxyquinolinato)aluminium (Alq₃) as the host matrix compound and 4-(dicyanomethylene)-2-methyl-6-(p-dimethylaminostyryl)-4H-pyran (DCM) as the guest emitter.

Various examples of host materials, guest emitters, and single-component host-emitting materials are described in Chaskar et al., "Bipolar Host Materials: A Chemical Approach for Highly Efficient Electrophosphorescent Devices," Adv. Mater., 23(34): 3876-3895 (2011); Tao et al., "Organic host materials for phosphorescent organic light-emitting diodes," Chem. Soc. Rev., 40(5): 2943-2970 (2011); Sasabe et al., "Multifunctional Materials in High-Performance OLEDs: Challenges for Solid-State Lighting," Chem. Mater., 23(3): 621-630 (2011); Tsuboi, "Recent advances in white organic light emitting diodes with a single emissive dopant," J. Non-Cryst. Solids, 356(37-40): 1919-1927 (201); Singh et al., "Bio-organic optoelectronic devices using DNA," Adv. Polym. Sci., 223 (Organic Electronics): 189-212 (2010); Kappaun et al., "Phosphorescent organic light-emitting devices: working principle and iridium based emitter materials," Int. J. Mol. Sci., 9(8): 1527-1547 (2008); Tokito et al., "Phosphorescent organic light-emitting devices: triplet energy management," Electrochemistry, 76(1): 24-31 (2008); Chen, "Evolution of Red Organic Light-Emitting Diodes: Materials and Devices," Chem. Mater., 16(23): 4389-4400 (2004); Liu et al., "Polyfluorenes with on-chain metal centers," Adv. Poly. Sci., 212 (Polyfluorenes): 125-144 (2008); Danev et al., "Vacuum deposited polyimide - a perfect matrix for nanocomposite materials," J. Optoelectron. Adv. Mater., 7(3): 1179-1190 (2005); U.S. Patent No. 5,747,183; U.S. Patent No. 5,683,823; U.S. Patent No. 6,626,722; U.S. Patent No. 7,074,502; U.S. Patent No. 7,671,241; and U.S. Patent No. 7,772,762.

To illustrate, some exemplary host-emitting materials include phosphorescent host-emitting compounds based on carbazole derivatives, fluorene derivatives, or 9-naphthylanthracene derivatives, and fluorescent host-emitting compounds based on organometallic chelates such as tris(8-quinolinol) aluminum complexes. Some exemplary host materials include polymers such as poly(p-phenylene vinylene), poly(alkyphenylphenylvinylene), poly(alkyphenylphenylvinylene-co-alkoxyphenylenevinylene), polyfluorene, poly(n-vinylcarbazole), and copolymers thereof. Various carbazole compounds, triphenylamine compounds, including hybrids with oxadiazole or benzimidazole also have been used as host materials.

Some exemplary guest emitters (light-emitting dyes or dopants) include fluorescent dyes such as various perylene derivatives, anthracene derivatives, rubrene derivatives, carbazole derivatives, fluorene derivatives, and quinacridone derivatives, and phosphorescent emitters such as various transition metal complexes including Ir, Os, or Pt. Tests carried out by the applicant showed that light emission figures are further enhanced when the emissive layer is selected among TCTA:Ir(piq)₃, NP4-CBP:Ir(piq)₃, NP4-CBP:Ir(ppy), NP4-CBP:FIrpic. According to one embodiment, the layer of emissive material contains a concentration of a doping material (e.g. one of the above described transition metal complexes) that is comprised between 10 and 22% of the total weight of the emissive layer.

In certain embodiments, the n-type semiconductor material can include a bis(p-fluoroalkyl)phenyl-substituted oligomeric thiophene compound, where the oligomeric thiophene compound can have 2, 3, 4, 5 or 6 thiophene moieties, optionally where two or more of the thiophene moieties can be fused. For example, the bis(p-fluoroalkyl)phenyl-substituted oligomeric thiophene compound can be selected from the group consisting of a dithiophene, a quaterthiophene, and a thienothiophene,

The inventors have found that the foregoing organic electroluminescent transistors can have enhanced emissive properties if the n-type semiconductor material includes an electron-transporting compound represented by formula (N-1): 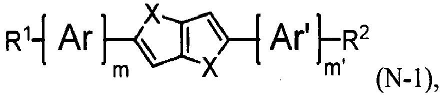 wherein:
X is selected from the group consisting of S, O, and Se;
Ar and Ar', at each occurrence, independently are identical or different monocyclic aryl or heteroaryl groups;
R¹ and R² independently are identical or different electron-withdrawing groups selected from the group consisting of -CN, R³, -C(O)R⁴, and -C(O)OR⁴; wherein R³ is an alkyl, alkenyl, or alkynyl group substituted with one or more F or CN groups, and R⁴ is an alkyl, alkenyl, or alkynyl group optionally substituted with one or more F or CN groups; and
m and m' independently are 1 or 2.

For example, R¹ and R² can be R³ which is selected from the group consisting of (i) a C₁₋₂₀ alkyl group substituted with one or more F or CN groups having the general formula CₓF_{y}H_{2x+1-y} or CₓCN_{y}H_{zx+1-y}, provided that x is an integer ranging between 1 and 20, y is an integer ranging between 1 and 41, and y ≤ 2x+1; (ii) a C₂₋₂₀ alkenyl group substituted with one or more F or CN groups having the general formula CₓF_{y}H_{2x-1-y} or CₓCN_{y}H_{2x-1-y}, provided that x is an integer ranging between 2 and 20, y is an integer ranging between 1 and 39, and y ≤ 2x-1; (iii) a C₂₋₂₀ alkynyl group substituted with one or more F or CN groups having the general formula CₓF_{y}H_{2x-3-y} or CₓCN_{y}H₂ₓ₋₃₋y, provided that x is an integer ranging between 2 and 20, y is an integer ranging between 1 and 37, and y ≤ 2x-3. In certain embodiments, R¹ and R² can be a C₁₋₂₀ alkyl group substituted with one or more F groups having the general formula CₓF_{y}H_{2+1-y}, provided that x is an integer ranging between 1 and 20, y is an integer ranging between 1 and 41, and y ≤ 2x+1. In particular embodiments, R¹ and R² can be a C₁₋₁₈ perfluoroalkyl group having the general formula CₙF₂ₙ₊₁, provided that n is an integer ranging between 1 and 20.

In other embodiments, R¹ and R² can be -C(O)R⁴ or -C(O)OR⁴, where R⁴ is selected from the group consisting of (i) H, (ii) a C₁₋₁₈ alkyl group optionally substituted with one or more F or CN groups having the general formula CₓF_{y}H_{2x+1-y} or CₓCN_{y}H_{2x+1-y}, provided that x is an integer ranging between 1 and 20, y is an integer ranging between 0 and 41, and y ≤ 2x+1 (ii) a C₂₋₁₈ alkenyl group optionally substituted with one or more F or CN groups having the general formula CₓF_{y}H_{2x-1-y} or CₓCN_{y}H₂ₓ₋₁₋y, provided that x is an integer ranging between 2 and 20, y is an integer ranging between 0 and 39, and y ≤ 2x-1; and (iii) a C₂₋₁₈ alkynyl group substituted with one or more F or CN groups having the general formula CₓF_{y}H_{2x-3-y} or CₓCN_{y}H_{2x-3-y}, provided that x is an integer ranging between 2 and 20, y is an integer ranging between 0 and 37, and y ≤ 2x-3.

In preferred embodiments, the electron-transporting compound can be represented by formula (N-2): 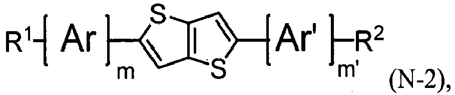 wherein Ar, Ar', R¹, R², m and m' are as defined herein.

In more preferred embodiments, the electron-transporting compound can be represented by formula (N-3): 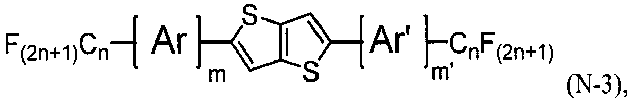 wherein n is an integer ranging from 1 to 12 (inclusive), preferably, from 4 to 12 (inclusive), and wherein Ar, Ar', m and m' are as defined herein.

In any of the foregoing embodiments, Ar and Ar', at each occurrence, independently can be selected from the group consisting of a phenyl group, a thienyl group, a thiazolyl group, an isothiazolyl group, a thiadiazolyl group, a furyl group, an oxazolyl group, an isoxazolyl group, an oxadiazolyl group, a pyrrolyl group, a triazolyl group, a tetrazolyl group, a pyrazolyl group, an imidazolyl group, a pyridyl group, a pyrimidyl group, a pyridazinyl group, and a pyrazinyl group.

In particular embodiments, the electron-transporting compound can be represented by formula (N-4): 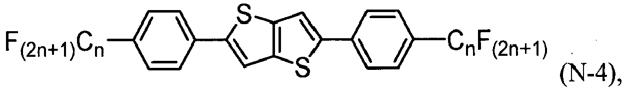 wherein n is an integer ranging from 1 to 12 (inclusive), and preferably, from 4 to 12 (inclusive).

In one specific embodiment, the electron-transporting compound can be 2,5-bis(4-(perfluorooctyl)phenyl)thieno[3,2-b]thiophene (N-F2-6):

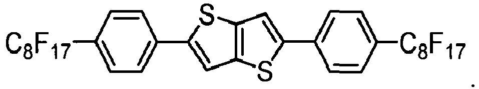

In another specific embodiment, the electron-transporting compound can be 2,5-bis(4-(trifluoromethyl)phenyl)thieno[3,2-b]thiophene (NF2-6-CF3):

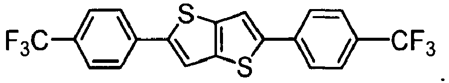

The dielectric layer can be an electrically insulating material selected from the group consisting of an inorganic oxide or nitride, a molecular dielectric, a polymeric dielectric, and combination thereof. In embodiments where the dielectric layer is a metal oxide or nitride, such dielectric material can be selected from the group consisting of SiO₂, Si₃N₄, Al₂O₃, ZrOₓ, Al-doped ZrOₓ, and HfOₓ. In embodiments where the dielectric layer is a molecular dielectric, such dielectric can be a self-assembled nanodielectric. In embodiments where the dielectric layer is a polymeric dielectric, such dielectric material can be selected from the group consisting of polyolefins, polyacrylates, polyimides, polyesters, and fluoropolymers. Hybrid organic/inorganic materials also may be used. In preferred embodiments, the dielectric layer comprises an organic dielectric, particularly, a polymeric dielectric.

OLETs according to the present invention can be fabricated using processes known in the art. For example, organic layers (e.g., the layer of emissive material, the layers of p-type and n-type semiconductor materials, and the organic dielectric layer of certain embodiments) can be formed by vapor-phase processes such as chemical vapor deposition or physical vapor deposition, as well as solution-phase processes such as printing (e.g., flexo printing, litho printing, gravure printing, ink-jetting, pad printing, and so forth), drop casting, slot coating, dip coating, doctor blading, roll coating, or spin-coating.

The hole/electron and gate electrodes can be formed using conventional processing techniques. For example, any of the electrical contacts can be deposited through a mask, or can be deposited then etched or lifted off (photolithography). Suitable deposition techniques include electrodeposition, vaporization, sputtering, electroplating, coating, laser ablation and offset printing, from the same or different metals or metal alloys such as copper, aluminum, gold, silver, molybdenum, platinum, palladium, copper, titanium, chromium, and/or nickel, a transparent conducting oxide such as tin-doped indium oxide (ITO), or an electrically conductive polymer such as polyethylenethioxythiophene (PEDOT). Charge carrier injection can be facilitated by the use of a material for the injection electrode (hole electrode or electron electrode) that has a low barrier against injection of a charge carrier type into the hole transport sublayer and the electron transport sublayer, respectively. For example, the electron electrode can comprise one or more elements selected from the group consisting of Au, Ca, Mg, Al, In, and a perovskite manganites (RE₁₋ₓAₓMnO₃, RE = rare earth element such as La, Nd, Pr etc., A = alkaline metal). The hole electrode can comprise at least one material selected from the group consisting of Au, indium tin oxide, Cr, Cu, Fe, Ag, poly(3,4-ethylenedioxthiophene) combined with poly(styrenesulfonate) (PEDOT:PSS), and a perovskite manganite (Re₁₋ₓAₓMnO₃). In certain embodiments, the hole electrode and the electron electrode can be made of conductors with different work functions to favor both hole and electron injection.

If present, the hole and electron injection sublayers can be prepared by self-assembly of thiolates, phosphonates, or aliphatic or aromatic carboxylates; by thermal evaporation of various charge transfer complexes and other heteroaromatic or organometallic complexes; or by thermal evaporation or sputtering of various metal oxides, fluorides, or carbonates. The hole injection sublayer and the electron injection sublayer can be made of materials that provide a staircase of electronic levels between the energy level of the hole electrode and the electron electrode, and the energy level required for injection into the hole transport sublayer and the electron transport sublayer, respectively. *See e.g.,* Li et al., "Low operating-voltage and high power-efficiency OLED employing MoO3-doped CuPc as hole injection layer," Displays, 33(1): 17-20 (2012); Wen et al., "Self-assembled of conducting polymeric nanoparticles and its application for OLED hole injection layer," Energy Procedia, 12: 609-614 (2011); Zhang et al., "Role of Fe3O4 as a p-dopant in improving the hole injection and transport of organic light-emitting devices," IEEE Journal of Quantum Electronics, 47(5): 591-596 (2011); Choo et al., "Luminance and charge transport mechanisms for phosphorescent organic light-emitting devices fabricated utilizing a tris(2-phenylpyridine)iridium-doped N,N'-dicarbazolyl-3,5-benzene emitting layer," Thin Solid Films, 519(15): 5253-5256 (2011); Tao et al., "Odd-even modulation of electrode work function with self-assembled layer: Interplay of energy barrier and tunneling distance on charge injection in organic light-emitting diodes," Organic Electronics, 12(4): 602-608 (2011); Sung et al., "AC Field-Induced Polymer Electroluminescence with Single Wall Carbon Nanotubes," Nano Letters, 11(3): 966-972 (2011); Qiao et al., "Controlling charge balance and exciton recombination by bipolar host in single-layer organic light-emitting diodes," Journal of Applied Physics, 108(3): 034508/1-034508/8 (2011); Khizar-ul-Haq et al., "Blue organic light-emitting diodes with low driving voltage and enhanced power efficiency based on MoO3 as hole injection layer and optimized charge balance," Journal of Non-Crystalline Solids, 356(20-22): 1012-1015 (2010); Qi et al., "Analysis of metal-oxide-based charge generation layers used in stacked organic light-emitting diodes," Journal of Applied Physics, 107(1): 014514/1-014514/8 (201); Huang et al., "Materials and interface engineering in organic light-emitting diodes," Organic Electronics, 243-261 (2010); Helander et al., "Comparison of Alq3/alkali-metal fluoride/A1 cathodes for organic electroluminescent devices," Journal of Applied Physics, 104(9): 094510/1-094510/6 (2008); Roy Choudhury et al., "LiF as an n-dopant in tris(8-hydroxyquinoline) aluminum thin films," Advanced Materials, 20(8): 1456-1461 (2008); Vacca et al., "Poly(3,4-ethylenedioxythiophene):poly(4-styrenesulfonate) ratio: Structural, physical and hole injection properties in organic light emitting diodes," Thin Solid Films, 516(12): 4232-4237 (2008); Yang et al., "Improved fabrication process for enhancing light emission in single-layer organic light-emitting devices doped with organic salt," Japanese Journal of Applied Physics, 47(2, Pt. 1): 1101-1103 (2008); Kim et al., "UV-ozone surface treatment of indium-tin-oxide in organic light emitting diodes," Journal of the Korean Physical Society, 50(6): 1858-1861 (2007); Prat et al., "Stable, highly efficient and temperature resistant organic light-emitting devices," Japanese Journal of Applied Physics, Part 1: Regular Papers, Brief Communications & Review Papers," 46(4A): 1727-1730 (2007); Luo et al., "Improving the stability of organic light-emitting devices by using a hole-injection-tunable-anode-buffer-layer," Journal of Applied Physics, 101(5): 054512/1-054512/4 (2007); Matsushima et al., "Charge-carrier injection characteristics at organic/organic heterojunction interfaces in organic light-emitting diodes," Chemical Physics Letters, 435(4-6): 327-330 (2007); Kim et al., "Controllable work function of Li-Al alloy nanolayers for organic light-emitting devices," Advanced Engineering Materials, 7(11): 1023-1027 (2005); Kato, "Designing Interfaces That Function to Facilitate Charge Injection in Organic Light-Emitting Diodes," Journal of the American Chemical Society, 127(33): 11538-11539 (2005); Veinot et al., "Toward the Ideal Organic Light-Emitting Diode. The Versatility and Utility of Interfacial Tailoring by Cross-Linked Siloxane Interlayers," Accounts of Chemical Research, 38(8): 632-643 (2005); Oyamada et al., "Extremely low-voltage driving of organic light-emitting diodes with a Cs-doped phenyldipyrenylphosphine oxide layer as an electron-injection layer," Applied Physics Letters, 86(3): 033503/1-033503/3 (2005); Hughes et al., "Electron-transporting materials for organic electroluminescent and electrophosphorescent devices," Journal of Materials Chemistry, 15(1): 94-107 (2005); D'Andrade et al., "Efficient organic electrophosphorescent white-light-emitting device with a triple doped emissive layer," Advanced Materials, 16(7): 624-628 (2004); Kanno et al., "Development of OLED with high stability and luminance efficiency by co-doping methods for full color displays," IEEE Journal of Selected Topics in Quantum Electronics, 10(1): 30-36 (2004); Han et al., "Transparent-cathode for top-emission organic light-emitting diodes," Applied Physics Letters, 82(16): 2715-2717 (2003); Tutis et al., "Internal electric field and charge distribution in multilayer organic light-emitting diodes," Journal of Applied Physics, 93(8): 4594-4602 (2003); Mathai et al., "Controlled injection of holes into A1Q3 based OLEDs by means of an oxidized transport layer," Materials Research Society Symposium Proceedings, 708(Organic Optoelectronic Materials, Processing and Devices): 101-106 (2002); Crone et al., "Charge injection and transport in single-layer organic light-emitting diodes," Applied Physics Letters, 73(21): 3162-3164 (1998); and Park et al., "Charge injection and photooxidation of single conjugated polymer molecules," Journal of the American Chemical Society, 126(13): 4116-7 (2004).

OLETs according to the present teachings can be fabricated on various substrates including plastic, flexible substrates that have a low temperature resistance. Examples of such flexible substrates include polyesters such as polyethylene terephthalate, polyethylene naphthalate, polycarbonate; polyolefins such as polypropylene, polyvinyl chloride, and polystyrene; polyphenylene sulfides such as polyphenylene sulfide; polyamides; aromatic polyamides; polyether ketones; polyimides; acrylic resins; polymethylmethacrylate, and blends and/or copolymers thereof. In some embodiments, the substrate can be a rigid transparent substrate such as glass, quartz and VYCOR®. Substrate-gate materials commonly used in thin-film transistors also can be used. Examples include doped silicon wafer, tin-doped indium oxide (ITO) on glass, tin-doped indium oxide on polyimide or mylar film, aluminum or other metals alone or coated on a polymer such as polyethylene terephthalate, a doped polythiophene, and the like.

The thicknesses of the various layers may be adapted in order to optimize performances and scaling down of the electroluminescent transistor of this disclosure. In this regard it is preferable to have the thickness of the layer of p-type semiconductor material comprised between 5 and 50 nm, preferably between 15 and 45 nm, the thickness of the layer of n-type semiconductor material may be comprised between 30 nm and 60 nm and the thickness of the layer of emissive material may be comprised between 30 nm and 60 nm.

A plurality of OLETs can be arranged in a matrix to provide a display device. The display device can include optional driving and switching elements, compensating transistor elements, capacitors, and/or light-emitting diodes. Particularly, such optional driving and switching elements and compensating transistor elements can be organic field-effect transistors.

The following examples are provided to illustrate further and to facilitate understanding of the present disclosure and are not in any way intended to limit the invention.

Acronyms are used in the examples to represent certain chemical compounds. The table below provides the IUPAC names and the acronyms of such compounds:

| | |
|---|---|
| **C8**-**BTBT** | 2,7-dioctyl[1]benzo-thieno[3,2-b][1]benzothiophene |
| **C5-BTBT** | 2,7-dipentyl[1]benzo-thieno[3,2-b][1]benzothiophene |
| **DNTT** | dinaphtho[2,3-b:2',3'-f]thieno[3,2-b]thiophene |
| **DH4T** | 5,5'-bis(3-hexyl-2-thienyl)-2,2'-bithiophene |
| **N-F2-6** | 2,5-bis(4-(perfluorooctyl)phenyl)thieno[3,2-b]thiophene |
| **N-F2-6-CF3** | 2,5-bis(4-(trifluoromethyl)phenyl)thieno[3,2-b]thiophene |
| **N-F4-1** | 2,6-bis(4-heptadecafluorooctylphenyl)-dithieno[3,2-b:2',3'-d] thiophene |
| **DFH4T** | 5,5'-bis((5-perfluorohexyl)thiophen-2-yl)-2,2'-bithiophene |
| **TCTA** | 4,4',4"-tris(carbazole-9-yl)triphenylamine |
| **NP4-CBP** | 4,4'-bis(3,6-dineopentyl-9H-carbazole-9-yl)-1,'-biphenyl |
| **Ir(piq)₃** | tris(1-phenylisoquinoline)iridium(III) |
| **Ir(ppy)₃** | tris(2-phenylpyridine)iridium(III) |
| **FIrpic** | bis(4,6-difluorophenyl-pyridine)(picolinate)iridium(III) |
| **PtOEP** | 2,3,7,8,12,13,17,18-octaethylporphyrin-22,24-diide; platinum(2+) |
| **Alq₃** | tris(8-hydroxyquinolinato)aluminium |
| **DCM** | 4-(dicyanomethylene)-2-methyl-6-(4-dimethylaminostyryl)-4H-pyran |

### Example 1

Making reference to figure 1, an organic ambipolar light emitting field effect transistor of this disclosure with simultaneous maximum light emission brightness and efficiency was realized from a substrate that comprised a first layer 1 of glass on which there was a transparent electrode 2 made of ITO (Indium Tin Oxide), on which there was a 450 nm-thick dielectric layer 3 of poly(methyl methacrylate) (PMMA) fabricated by spin-coating and cured in vacuum environment at 90°C. An organic emissive ambipolar channel was sublimated in vacuum (10⁻⁷ mbar) and comprised:
- a hole transport layer 4 of p-type semiconductor material deposited over the layer of PMMA, in this case a layer of 15 nm film made of C8-BTBT sublimated at a rate of 0.1 Å/s, while the substrate was maintained at room temperature;
- an emissive layer 5 in contact with the hole transport layer 4, in this case a 60 nm-thick recombination layer composed of a host-guest organic structure (with guest dye concentration of 20%). TCTA was used as the host matrix and it was sublimated at a rate of 1 Å/s, while the substrate was maintained at room temperature. Ir(piq)₃ was used as the guest dye and it was sublimated at a rate of 0.25 Å/s, while the substrate was maintained at room temperature;
- an electron transport layer 6 in contact with the emissive layer 5, in this case a 45nm film of N-F2-6 sublimated at a rate of 0.1 Å/s, while the substrate was maintained at room temperature.

The metal source and drain electrodes 7 and 7', made of silver (Ag), were deposited in vacuum (10⁻⁶ mbar) and each had a thickness of 70 nm.

The device channel length (CL) and channel width (CW) were 70 µm and 12mm, respectively.

The so realized transistor showed the following characteristic parameters:
p-type threshold voltage = -40.1 V;
p-type-mobility = 5.2·10⁻¹ cm²/Vs;
n-type threshold voltage = 38.4 V;
n-type mobility= 3.6·10⁻³ cm²/Vs.

Current-voltage graphs of the organic electroluminescent transistor are shown in figures 2 and 3. The graph of figure 2 illustrates variations of the drain-source current (I_{DS}) (left scale - black curves) and the electro-luminescence optical output power (EL) (right scale - gray curves) as a function of the drain-source voltage (V_{DS}) at different values of the gate-source voltage (V_{GS}), whilst the source contact was grounded. The graph of figure 3 illustrates variations of the drain-source current (I_{DS}) (left scale - black curve) and of the electro-luminescence optical output power (EL) (right scale - gray curves) as a function of the gate-source voltage (V_{GS}) whilst the drain contact was maintained at a constant bias voltage of -100V and the source contact was grounded (V_{DS} = -100V).

Figure 4 shows graphs of the external quantum efficiency (EQE, left scale-black curve) and of the electro-luminescence optical output power EL (right scale-gray curves) as a function of the gate-source voltage V_{GS} whilst the drain contact was maintained at a constant bias voltage of -100V and the source contact was grounded (V_{DS} = -100V).

As shown in figure 4, the tested organic electroluminescent transistor which has an organic emissive ambipolar channel that includes a hole transport layer composed of a condensed polycyclic aromatic compound of general formula (P-I) (in this case, C8-BTBT) unexpectedly achieved maximum brightness (EL ∼ 45 µW) and efficiency (EQE > 2.25%) simultaneously.

### Example 2

Making reference to figure 1, an organic ambipolar light emitting field effect transistor of this disclosure with simultaneous maximum light emission brightness and efficiency was realized from a substrate that comprised a first layer 1 of glass on which there was a transparent electrode 2 made of ITO (Indium Tin Oxide), on which there was a 450 nm-thick dielectric layer 3 of poly(methyl methacrylate) (PMMA) fabricated by spin-coating and cured in vacuum environment at 90°C. An organic emissive ambipolar channel was sublimated in vacuum (10⁻⁷ mbar) and comprised:
- a hole transport layer 4 of p-type semiconductor material deposited over the layer of PMMA, in this case a layer of 15 nm film made of C5-BTBT sublimated at a rate of 0.1 Å/s, while the substrate was maintained at room temperature;
- an emissive layer 5 in contact with the hole transport layer 4, in this case a 60 nm thick recombination layer composed of a host-guest organic structure (with guest dye concentration of 20%). TCTA was used as the host matrix and it was sublimated at a rate of 1 Å/s, while the substrate was maintained at room temperature. Ir(piq)₃ was used as the guest dye and it was sublimated at a rate of 0.25 Å/s, while the substrate was maintained at room temperature;
- an electron transport layer 6 in contact with the emissive layer 5, in this case a 45nm film of N-F2-6 sublimated at a rate of 0.1 Å/s, while the substrate was maintained at room temperature.

The metal source and drain electrodes 7, made of silver (Ag), were deposited in vacuum (10⁻⁶ mbar) and each had a thickness of 70nm.

The device channel length (CL) and channel width (CW) were 70µm and 12mm, respectively.

The so realized transistor showed the following characteristic parameters:
p-type threshold voltage = -54.5 V;
p-type-mobility = 1.2·10⁻¹ cm²/Vs;
n-type threshold voltage = 25.9 V;
n-type mobility= 4.2·10⁻³ cm²/Vs.

Current-voltage graphs of the organic electroluminescent transistor are shown in figures 5 and 6. The graph of figure 5 illustrates variations of the drain-source current (I_{DS}) (left scale - black curves) and the electro-luminescence optical output power (EL) (right scale - gray curves) as a function of the drain-source voltage (V_{DS}) at different values of the gate-source voltage (V_{GS}), whilst the source contact was grounded. The graph of figure 6 illustrates variations of the drain-source current (I_{DS}) (left scale - black curve) and of the electro-luminescence optical output power (EL) (right scale - gray curves) as a function of the gate-source voltage (V_{GS}) whilst the drain contact was maintained at a constant bias voltage of -100V and the source contact was grounded (V_{DS}= -100V).

Figure 7 shows graphs of the external quantum efficiency (EQE, left scale-black curve) and of the electro-luminescence optical output power EL (right scale-gray curves) as a function of the gate-source voltage V_{GS} whilst the drain contact was maintained at a constant bias voltage of -100V and the source contact was grounded (V_{DS} = -100V).

As shown in figure 7, the tested organic electroluminescent transistor which has an organic emissive ambipolar channel that includes a hole transport layer composed of a condensed polycyclic aromatic compound of general formula (P-I) (in this case, C5-BTBT) unexpectedly achieved maximum brightness (EL > 50 µW) and efficiency (EQE > 2.5%) simultaneously.

### Example 3

Making reference to figure 1, an organic ambipolar light emitting field effect transistor of this disclosure with simultaneous maximum light emission brightness and efficiency was realized from a substrate that comprises a first layer 1 of glass on which there was a transparent electrode 2 made of ITO (Indium Tin Oxide), on which there was a 450nm-thick dielectric layer 3 of poly(methyl methacrylate) (PMMA) fabricated by spin-coating and cured in vacuum environment at 90°C. An organic emissive ambipolar channel was sublimated in vacuum (10⁻⁷ mbar) and comprised:
- a hole transport layer 4 of p-type semiconductor material deposited over the layer of PMMA, in this case a layer of 15 nm film made of DNTT sublimated at a rate of 0.1 Å/s, while the substrate was maintained at room temperature;
- an emissive layer 5 in contact with the hole transport layer 4, in this case a 60nm thick recombination layer composed of a host-guest organic structure (with guest dye concentration of 20%). TCTA was used as the host matrix and it was sublimated at a rate of 1 Å/s, while the substrate was maintained at room temperature. Ir(piq)₃ was used as the guest dye and it was sublimated at a rate of 0.25 Å/s, while the substrate was maintained at room temperature;
- an electron transport layer 6 in contact with the emissive layer 5, in this case a 45nm film of N-F2-6 sublimated at a rate of 0.1 Å/s, while the substrate was maintained at room temperature.

The metal source and drain electrodes 7, made of silver (Ag), were deposited in vacuum (10⁻⁶ mbar) and each had a thickness of 70nm.

The device channel length (CL) and channel width (CW) were 70µm and 12mm, respectively.

The so realized transistor showed the following characteristic parameters:
p-type threshold voltage = -40 V;
p-type-mobility = 5·10⁻⁵ cm²/Vs;
n-type threshold voltage = 34 V;
n-type mobility= 0.5 cm²/Vs.

Current-voltage graphs of the organic electroluminescent transistor are shown in figures 8 and 9. The graph of figure 8 illustrates variations of the drain-source current (I_{DS}) (left scale - black curves) and the electro-luminescence optical output power (EL) (right scale - gray curves) as a function of the drain-source voltage (V_{DS}) at different values of the gate-source voltage (V_{GS}), whilst the source contact was grounded. The graph of figure 9 illustrates variations of the drain-source current (I_{DS}) (left scale - black curve) and of the electro-luminescence optical output power (EL) (right scale - gray curves) as a function of the gate-source voltage (V_{GS}) whilst the drain contact was maintained at a constant bias voltage of -100V and the source contact was grounded (V_{DS} = -100V).

Figure 10 shows graphs of the external quantum efficiency (EQE, left scale-black curve) and of the electro-luminescence optical output power EL (right scale-gray curves) as a function of the gate-source voltage V_{GS} whilst the drain contact was maintained at a constant bias voltage of -100V and the source contact was grounded (V_{DS} =-100V).

As shown in figure 10, the tested organic electroluminescent transistor which has an organic emissive ambipolar channel that includes a hole transport layer composed of a condensed polycyclic aromatic compound of general formula (P-I) (in this case, DNTT) unexpectedly achieved maximum brightness (EL ∼ 20 µW) and efficiency (EQE ∼ 2.5%) simultaneously.

In contrast to the data obtained in Examples 1-3, organic electroluminescent transistors having an organic emissive ambipolar channel that includes a hole transport layer composed of p-type compounds not within general formula (P-I) were found to have both significantly lower light emission brightness and efficiency. These comparative devices are described in Examples 4-6.

### Example 4 (Comparative)

The comparative device tested in this example incorporated the p-type semiconductor material (DH4T, a bis(alkyl-substituted) oligothiophene), the n-type semiconductor material (DFH4T), and the emissive material (Alq₃:DCM) used in the organic light-emitting transistor reported in the article "Organic light-emitting transistors with an efficiency that outperforms the equivalent light-emitting diodes" published in 2010 by Nature Materials, Volume 9, pages 496-503.

Making reference to figure 1, a comparative organic ambipolar light emitting field effect transistor was realized from a substrate that comprised a first layer 1 of glass on which there was a transparent electrode 2 made of ITO (Indium Tin Oxide), on which there was a 450 nm-thick dielectric layer 3 of poly(methyl methacrylate) (PMMA) fabricated by spin-coating and cured in vacuum environment at 90°C. An organic emissive ambipolar channel was sublimated in vacuum (10⁻⁷ mbar) and comprised:
- an electron transport layer 4 of n-type semiconductor material deposited over the layer of PMMA, in this case a layer of 15 nm film made of DFH4T sublimated at a rate of 0.1 Å/s, while the substrate was maintained at room temperature;
- an emissive layer 5 in contact with the hole transport layer 4, in this case a 60 nm-thick recombination layer composed of a host-guest organic structure (with guest dye concentration of 20%). Alq₃ was used as the host matrix and it was sublimated at a rate of 1 Å/s, while the substrate was maintained at room temperature. DCM was used as the guest dye and it was sublimated at rate of 0.25 Å/s, while the substrate was maintained at room temperature;
- a hole transport layer 6 in contact with the emissive layer 5, in this case a 45nm film of DH4T sublimated at a rate of 0.1Å/s, while the substrate was maintained at room temperature.

The metal source and drain electrodes 7, made of silver (Ag), were deposited in vacuum (10⁻⁶ mbar) and each had a thickness of 70nm.

The device channel length (CL) and channel width (CW) were 70µm and 12mm, respectively.

The so realized transistor showed the following characteristic parameters:
p-type threshold voltage = -60 V;
p-type-mobility = 5.3·10⁻¹ cm²/Vs;
n-type threshold voltage = 23.7 V;
n-type mobility= 3.6·10⁻³ cm²/Vs.

Current-voltage graphs of the organic electroluminescent transistor are shown in figures 11 and 12. The graph of figure 11 illustrates variations of the drain-source current (I_{DS}) (left scale - black curves) and the electro-luminescence optical output power (EL) (right scale - gray curves) as a function of the drain-source voltage (V_{DS}) at different values of the gate-source voltage (V_{GS}), whilst the source contact was grounded. The graph of figure 12 illustrates variations of the drain-source current (I_{DS}) (left scale - black curve) and of the electro-luminescence optical output power (EL) (right scale - gray curves) as a function of the gate-source voltage (V_{GS}) whilst the drain contact was maintained at a constant bias voltage of 90V and the source contact was grounded (V_{DS} = 90V).

Figure 13 shows graphs of the external quantum efficiency (EQE, left scale-black curve) and of the electro-luminescence optical output power EL (right scale-gray curves) as a function of the gate-source voltage V_{GS} whilst the drain contact was maintained at a constant bias voltage of 90V and the source contact was grounded (V_{DS} = 90V).

As shown in figure 13, the comparative device tested in this example, which incorporated a combination of materials previously reported in the art, showed much lower brightness (EL < 0.25 µW) and efficiency (EQE < 0.8%) compared to the devices of Examples 1-3. Further, the maximum brightness was obtained under conditions when the efficiency was very low, and vice versa.

### Example 5 (Comparative)

Making reference to figure 1, a second comparative organic ambipolar light emitting field effect transistor was realized from a substrate that comprised a first layer 1 of glass on which there was a transparent electrode 2 made of ITO (Indium Tin Oxide), on which there was a 450 nm-thick dielectric layer 3 of poly(methyl methacrylate) (PMMA) fabricated by spin-coating and cured in vacuum environment at 90°C. An organic emissive ambipolar channel was sublimated in vacuum (10⁻⁷ mbar) and comprised:
- a hole transport layer 4 of p-type semiconductor material deposited over the layer of PMMA, in this case a layer of 15 nm film made of DH4T sublimated at a rate of 0.1 Å/s, while the substrate was maintained at room temperature;
- an emissive layer 5 in contact with the hole transport layer 4, in this case a 60nm thick recombination layer composed of a host-guest organic structure (with guest dye concentration of 20%). Alq₃ was used as the host matrix and it was sublimated at a rate of 1 Å/s, while the substrate was maintained at room temperature. PtOEP was used as the guest dye and it was sublimated at rate of 0.25 Å/s, while the substrate was maintained at room temperature;
- an electron transport layer 6 in contact with the emissive layer 5, in this case a 45nm film of N-F4-1 sublimated at a rate of 0.1 Å/s, while the substrate was maintained at room temperature.

The metal source and drain electrodes 7, made of silver (Ag), were deposited in vacuum (10⁻⁶ mbar) and each had a thickness of 70nm.

The device channel length (CL) and channel width (CW) are 70µm and 12mm, respectively.

The so realized transistor showed the following characteristic parameters:
p-type threshold voltage = -55.2 V;
p-type-mobility = 3.8·10⁻² cm²/Vs;
n-type threshold voltage = null;
n-type mobility= null.

Current-voltage graphs of the organic electroluminescent transistor are shown in figures 14 and 15. The graph of figure 14 illustrates variations of the drain-source current (I_{DS}) (left scale - black curves) and the electro-luminescence optical output power (EL) (right scale - gray curves) as a function of the drain-source voltage (V_{DS}) at different values of the gate-source voltage (V_{GS}), whilst the source contact was grounded. The graph of figure 15 illustrates variations of the drain-source current (I_{DS}) (left scale - black curve) and of the electro-luminescence optical output power (EL) (right scale - gray curves) as a function of the gate-source voltage (V_{GS}) whilst the drain contact was maintained at a constant bias voltage of -100V and the source contact was grounded (V_{DS} = -100V).

Figure 16 shows graphs of the external quantum efficiency (EQE, left scale-black curve) and of the electro-luminescence optical output power EL (right scale-gray curves) as a function of the gate-source voltage V_{GS} whilst the drain contact was maintained at a constant bias voltage of -100V and the source contact was grounded (V_{DS} = -100V).

As shown in figure 16, the comparative device tested in this example showed much lower brightness (EL < 0.30 µW) and efficiency (EQE < 0.9%) compared to the devices of Examples 1-3. Further, the maximum brightness was obtained under conditions when the efficiency was not optimized, and vice versa.

### Example 6 (Comparative)

The comparative device tested in this example incorporated pentacene as the p-type semiconductor material in the ambipolar channel. Pentacene is considered in the art as the benchmark for organic p-type semiconductors, with reported mobilities greater than 1 cm²/Vs.

Making reference to figure 1, a comparative organic ambipolar light emitting field effect transistor was realized from a substrate that comprised a first layer 1 of glass on which there was a transparent electrode 2 made of ITO (Indium Tin Oxide), on which there was a 450nm-thick dielectric layer 3 of poly(methyl methacrylate) (PMMA) fabricated by spin-coating and cured in vacuum environment at 90°C. An organic emissive ambipolar channel was sublimated in vacuum (10⁻⁷ mbar) and comprised:
- a hole transport layer 4 of p-type semiconductor material deposited over the layer of PMMA, in this case a layer of 15 nm film made of pentacene sublimated at rate of 0.1 Å/s, while the substrate was maintained at room temperature;
- an emissive layer 5 in contact with the hole transport layer 4, in this case a 30nm thick recombination layer composed of Alq₃ sublimated at a rate of 6 Å/s, while the substrate was maintained at room temperature.
- an electron transport layer 6 in contact with the emissive layer 5, in this case a 15nm film of DFH4T sublimated at a rate of 0.1 Å/s, while the substrate was maintained at room temperature.

The metal source and drain electrodes 7, made of gold (Au), were deposited in vacuum (10⁻⁶ mbar) and each had a thickness of 50 nm.

The device channel length (CL) and channel width (CW) were 70µm and 12mm, respectively.

The so realized transistor showed the following characteristic parameters:
p-type threshold voltage = -31.4 V;
p-type-mobility = 0.27 cm²/Vs;
n-type threshold voltage = null;
n-type mobility= null.

Current-voltage graphs of the organic electroluminescent transistor are shown in figures 17 and 18. The graph of figure 17 illustrates variations of the drain-source current (I_{DS}) (left scale - black curves) and the electro-luminescence optical output power (EL) (right scale - gray curves) as a function of the drain-source voltage (V_{DS}) at different values of the gate-source voltage (V_{GS}), whilst the source contact was grounded. The graph of figure 18 illustrates variations of the drain-source current (I_{DS}) (left scale - black curve) and of the electro-luminescence optical output power (EL) (right scale - gray curves) as a function of the gate-source voltage (V_{GS}) whilst the drain contact was maintained at a constant bias voltage of -100V and the source contact was grounded (V_{DS} = -100V).

Figure 19 shows graphs of the external quantum efficiency (EQE, left scale-black curve) and of the electro-luminescence optical output power EL (right scale-gray curves) as a function of the gate-source voltage V_{GS} whilst the drain contact was maintained at a constant bias voltage of -100V and the source contact was grounded (V_{DS} = -100V).

As shown in figure 19, despite the high p-type mobility of pentacene, the comparative device tested in this example showed very low brightness (EL < 0.08 µW) and efficiency (EQE < 0.004%) compared to the devices of Examples 1-3.

Examples 1, 2 and 3 demonstrate that organic electroluminescent transistors which have an organic emissive ambipolar channel that includes a hole transport layer composed of a condensed polycyclic aromatic compound of general formula (P-I) in general show a higher source-drain current and a higher optical output power (EL) compared to comparative devices described in examples 4, 5 and 6, which incorporates other p-type semiconductor compounds as the hole transport layer.

Moreover, the organic electroluminescent transistors of examples 1, 2 and 3 show significantly higher emission quantum efficiencies (EQE) values (see Figs. 4, 7 and 10, left scale) compared to the comparative devices described in examples 4, 5 and 6. The EQE values of the transistors of examples 1, 2 and 3 oscillate around a constant value during gate bias sweep (oscillations within 10-20% of maximum EQE value) providing simultaneous achievement of maximum brightness and efficiency. In example 4 (Fig. 13, left scale), a substantial deterioration of EQE was observed at increased gate biases (a decrease of about 40% with respect to its maximum value occurred). Analogous deterioration was observed with example 5. The EQE values of the comparative device described in Example 6 are extremely low (10⁻³ %).

That the devices demonstrated in Examples 1, 2, and 3 showed such high optical output power and efficiency was made more unexpected by the fact that a polymeric dielectric (PMMA) was used as the dielectric layer, compared to conventional OLETs and OFETs which typically show optimal device performance when an inorganic dielectric such as SiOₓ is used as the dielectric layer.

## Claims

1. An organic electroluminescent transistor, comprising at least one dielectric layer; at least one control electrode and an assembly comprising an emissive ambipolar channel, at least one source electrode and at least one drain electrode, wherein:
said dielectric layer is arranged between said control electrode and said assembly;
said ambipolar channel comprises at least one layer of an n-type semiconductor material, at least one layer of a p-type semiconductor material and at least one layer of an emissive material arranged between said layers of p-type and n-type semiconductor materials;
said p-type semiconductor layer is suitable to transport holes across the ambipolar channel of the transistor
**characterized in that**
said p-type semiconductor material comprises a condensed polycyclic aromatic compound having general formula (P-I) 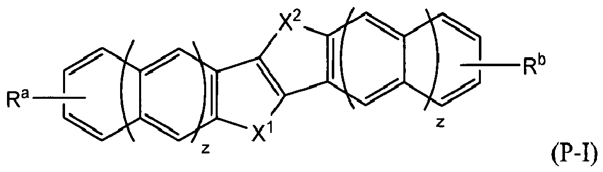 wherein
X¹ and X² are selected from the group consisting of S, O and Se;
R^{a} and R^{b} are independently selected from the group consisting of H, a C₁₋₁₈ alkyl group, and a C₆₋₁₄ aryl group, wherein each C₁₋₁₈ alkyl group and each C₆₋₁₄ aryl group optionally can be substituted with a phosphonate group; and z is 0 or 1.

2. An organic electroluminescent transistor according to claim 1 wherein at least one of R^{a} and R^{b} is a C₁₋₁₈ alkyl group substituted with a phosphonate group.

3. An organic electroluminescent transistor according to claim 1 where said p-type semiconductor material comprises a benzothieno-benzothiophene compound having general formula (P-II)

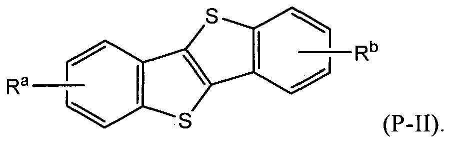

4. An organic electroluminescent transistor according to claim 3 where said p-type semiconductor material comprises a benzothieno-benzothiophene compound having general formula

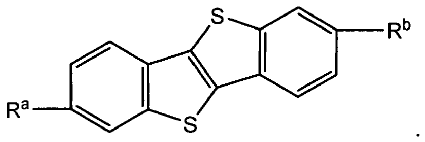

5. An organic electroluminescent transistor according to claim 3 where said p-type semiconductor material comprises a benzothieno-benzothiophene compound having general formula

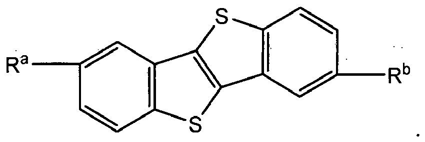

6. An organic electroluminescent transistor according to claim 1 where said p-type semiconductor material comprises a dinaphtho-thienothiophene compound having general formula (P-III)

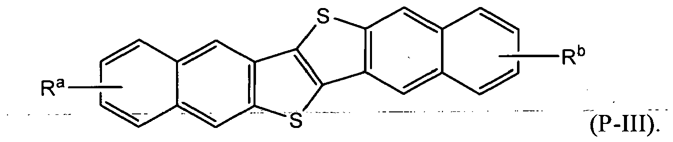

7. An organic electroluminescent transistor according to claim 6 where said p-type semiconductor material comprises a dinaphtho-thienothiophene compound having general formula

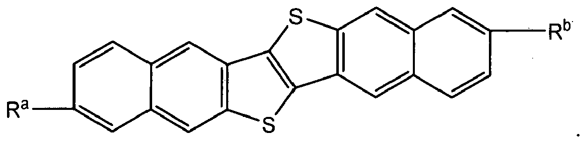

8. An organic electroluminescent transistor according to claim 6 where said p-type semiconductor material comprises a dinaphtho-thienothiophene compound having general formula

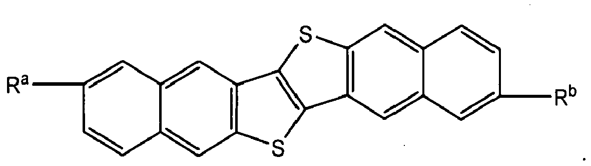

9. An organic electroluminescent transistor according to any one of claims 1-8, wherein R^{a} and R^{b} are identical C₁₋₁₈ alkyl group.

10. An organic electroluminescent transistor according to any one of claims 1-8, wherein R^{a} and R^{b} are identical C₃₋₁₂ alkyl groups.

11. An organic electroluminescent transistor according to claim 10, wherein R^{a} and R^{b} are identical linear C₃₋₁₂ alkyl groups.

12. An organic electroluminescent transistor according to claim 1 where said p-type semiconductor material comprises a compound selected among benzothieno-benzothiophene compounds having general formula 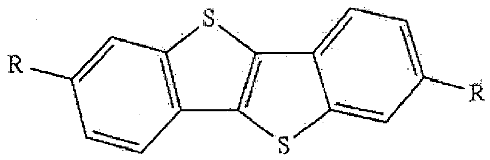 R being phenyl groups.

13. An organic electroluminescent transistor according to claim 1 wherein said n-type semiconductor material comprises a bis(p-fluoroalkyl)phenyl-substituted oligomeric thiophene compound, wherein the oligomeric thiophene compound has 2, 3, 4, 5 or 6 thiophene moieties, optionally wherein two or more of the thiophene moieties are fused.

14. An organic electroluminescent transistor according to claim 13 wherein the bis(p-fluoroalkyl)phenyl-substituted oligomeric thiophene compound is selected from the group consisting of a dithiophene, a quaterthiophene, and a thienothiophene.

15. An organic electroluminescent transistor according to claim 1 wherein the thickness of said layer of p-type semiconductor material is comprised between 5 and 50 nm.

16. An organic electroluminescent transistor according to claim 15 wherein the thickness of said layer of p-type semiconductor material is comprised between 15 and 45 nm.

17. An organic electroluminescent transistor according to claim 1, **characterized in that** the thickness of said layer of n-type semiconductor material is comprised between 30 nm and 60 nm.

18. An organic electroluminescent transistor according to claim 1, **characterized in that** said layer of emissive material has a thickness between 30 nm and 60 nm.

19. An organic electroluminescent transistor according to claim 1, **characterized in that** said layer of emissive material contains a concentration of a transition metal complex that is comprised between 10 and 22% of the total weight of said emissive layer.

20. An organic electroluminescent transistor according to claim 1 wherein said source electrode is in contact with said layer of p-type semiconductor material and said drain electrode is in contact with said layer of n-type semiconductor material.

21. An organic electroluminescent transistor according to claim 1 wherein said source electrode and said drain electrode are composed of at least one different material.

22. An organic electroluminescent transistor according to claim 1 wherein an injection sublayer is interposed between said source electrode and the layer of p-type or n-type semiconductor material and/or an injection sublayer is interposed between said drain electrode and the layer of the p-type or n-type semiconductor material.

23. An organic electroluminescent transistor according to claim 1, wherein each of the control electrode, drain electrode, and source electrode independently comprises a metal or a transparent conducting oxide selected from the group consisting of gold, silver, molybdenum, copper, titanium, chromium, tin-doped indium oxide and combination thereof.

24. An organic electroluminescent transistor according to claim 1, wherein the dielectric layer comprises an electrically insulating material selected from the group consisting of an inorganic oxide or nitride, a molecular dielectric, a polymeric dielectric, and combination thereof.

25. An organic electroluminescent transistor according to claim 1, wherein the inorganic oxide or nitride is selected from the group consisting of SiO₂, Si₃N₄, Al₂O₃, ZrOₓ, Al-doped ZrOₓ, and HfOₓ.

26. An organic electroluminescent transistor according to claim 1, further comprising a passivation layer covering a top surface of the emissive ambipolar channel.

27. An optoelectronic device for producing an image, the optoelectronic device comprising a plurality of identical or different organic electroluminescent transistors according to any one of previous claims, interconnected to each other and deposited on a substrate.
